# EUROPÄISCHE PATENTSCHRIFT

(11) **EP 4 267 286 B1**
(45) Veröffentlichungstag und Bekanntmachung des Hinweises auf die Patenterteilung: **04.03.2026**
(21) Anmeldenummer: 21847706.5
(22) Anmeldetag: 28.12.2021
(51) Int. Cl.: B01D 69/00

(54) **VORRICHTUNG UND VERFAHREN ZUR SEPARATION VON PARTIKELN IN EINER FLÜSSIGKEIT, KIT ENTHALTEND DIE VORRICHTUNG UND VERWENDUNGEN DER VORRICHTUNG**
DEVICE AND METHOD OF SEPARATING PARTICLES IN A FLUID, KIT WITH THE DEVICE AND USE OF THE DEVICE
DISPOSITIF ET METHODE DE SEPARATION DE PARTICULES DANS UN FLUIDE, KIT AVEC LE DISPOSITIF ET UTILISATION DU DISPOSITIF

(30) Priorität: 28.12.2020 DE 102020216579
(43) Veröffentlichungstag der Anmeldung: 01.11.2023
(73) Patentinhaber: Fraunhofer-Gesellschaft zur Förderung der angewandten Forschung e.V., 80686 München (DE); Technische Universität Dresden, 01069 Dresden (DE); Cell.Copedia GmbH, 04109 Leipzig (DE)
(72) Erfinder: Gerdes, Willhelm, 04109 Leipzig (DE); Berthold, Rommy, 04109 Leipzig (DE); Schmieder, Florian, 01277 Dresden (DE); Langer, Maurice, 01277 Dresden (DE); Katzer, Konrad, 01277 Dresden (DE)
(74) Vertreter: Pfenning, Meinig & Partner mbB
(86) Internationale Anmeldenummer: PCT/EP2021/087733
(87) Internationale Veröffentlichungsnummer: WO 2022/144359

(56) Entgegenhaltungen:
- WO-A1-00/54866
- US-A1- 2015 299 415
- US-A1- 2016 199 561
- US-A1- 2017 296 979
- US-A1- 2018 290 106
- WANDERA D ET AL: "Stimuli-responsive membranes", JOURNAL OF MEMBRANE SCIENCE, ELSEVIER BV, NL, vol. 357, no. 1-2, 15 July 2010 (2010-07-15), pages 6 - 35, XP027054005, ISSN: 0376-7388, [retrieved on 20100409]

## Beschreibung

Es wird eine Vorrichtung, ein Verfahren und ein Kit zur Separation von unterschiedlich großen Partikeln in einer Flüssigkeit bereitgestellt. Zudem werden Verwendungen der Vorrichtung vorgeschlagen. Die Vorrichtung und das Verfahren beruhen darauf, dass Partikel in einer Flüssigkeit an Festphase-Partikel mit einem unterschiedlichen Durchmesser gebunden werden können, wodurch der hydrodynamische Durchmesser der Festphase-Partikel bestimmt, ob die Partikel Poren eines Filterelement passieren können, deren Durchmesser gezielt verändert (z.B. vergrößert oder verkleinert) werden kann. Es können somit auch gleich große Partikel (z.B. B-Zellen und T-Zellen) einer Flüssigkeit mit einer hohen Trennschärfe voneinander getrennt werden, wobei die Separation der Partikel einfach, schnell und kostengünstig erfolgen kann. Es können hohe Ausbeuten realisiert werden und die Partikel lassen sich in einer therapeutisch verwendbaren Flüssigkeit bereitstellen.

Zahlreiche zellbasierte Isolationsverfahren erfordern den Einsatz technischer Membranen, um Moleküle oder Partikel verschiedener Größen voneinander zu trennen. Bisher eingesetzte Membranen haben eine vorgegebene Poren- oder Maschenweite. Hierdurch werden Bestandteile, deren Größe die Porenweite überschreiten zurückgehalten, während kleinere Bestandteile die Membran passieren können. In vielen technischen Trennprozessen, wie bei der Aufreinigung von Partikeln aus Blut, sollen jedoch mehr als zwei verschieden große Partikel, d.h. verschieden große Blutzellen und/oder endosomale Vesikel) in hochreiner Qualität aufgetrennt werden. Derzeit ist man hierfür auf preisintensive und aufwendige Mehrstufen-Prozesse oder auf Reihenschaltungen von Membranen unterschiedlicher Porengröße angewiesen.

Im Stand der Technik ist ein Verfahren und eine Vorrichtung bekannt, über das/die eine bestimmte Art von Partikeln einer Flüssigkeit (z.B. bestimmte Zellen aus Vollblut) auf spezifische Art und Weise von den anderen Partikeln dieser Flüssigkeit separiert werden können (siehe WO 2016/092025 A1). Das Verfahren bzw. die Vorrichtung basiert auf einer spezifischen Bindung der Zielpartikel (z.B. Zielzellen) über niedrigaffine Fab-Fragmente an Festphase-Partikel, die zwischen zwei Membranen einer Membrankartusche immobilisiert sind. Die Zielpartikel können an die modifizierten Festphase-Partikel binden und andere Partikel (z.B. Zellen), die einen geringeren Durchmesser als der Porendurchmesser der beiden Membranen aufweisen und/oder die nicht an die Festphase-Partikel binden, werden von den Zielpartikeln abgetrennt.

Mit diesem bekannten Verfahren können die Zielzellen in einer hohen Reinheit und Ausbeute bereitgestellt werden. Aufgrund der fest vorgegebenen Porenweiten der in diesem Verfahren bzw. in dieser Vorrichtung eingesetzten Membranen (z.B. 45 µm) und der spezifischen Affinität der Fab-Fragmente für die Zielzellen ist jedoch eine Bereitstellung von mehreren Blutzellfraktionen mit jeweils einer Partikelart in einem einzelnen Schritt bzw. einer einzelnen Vorrichtung (Membrankartusche) nicht möglich. Zudem steht oft nur ein geringes Blutprobenvolumen zur Verfügung. Ein erfolgreiches Durchführen eines Trennverfahrens nach einem Aufteilen dieses geringen Probenvolumens auf mehrere Membrankartuschen mit unterschiedlich modifizierten Festphase-Partikeln ist oft nicht möglich. Es besteht somit ein Bedarf an einem Verfahren, mit dem in einer einzigen Vorrichtung eine Auftrennung einer Flüssigkeit mit Partikeln in mehrere Fraktionen, die jeweils eine bestimmte Partikelart enthalten, möglich ist.

Im Stand der Technik ist ein Filterelement zur Separation von unerwünschten Bestandteilen aus einem Fluidstrom bekannt, bei dem der Porendurchmesser der Poren des Filterelements durch Anlegen einer elektrische Spannung an das Filterelement und/oder durch Einwirken einer mechanischen Kraft auf das Filterelement verändert werden kann (siehe z.B. DE 10 2016 213 565 A1). Nachteilig an diesem Filterelement ist, dass die Veränderung der Porengröße gleichzeitig eine Veränderung der Form der Querschnittsfläche der Poren bewirkt (z.B. von einem rechteckigen Querschnitt zu einem rhombenförmigen Querschnitt oder von einem runden Querschnitt zu einem ovalen Querschnitt) und somit die Selektivität des Filterelements, Partikel bestimmter Geometrie passieren zu lassen, nicht mit hoher Präzision eingestellt werden kann.

Darüber hinaus sind im Stand der Technik Membranen bekannt, die dielektrische Elastomere enthalten oder daraus bestehen (siehe z.B. DE 10 2012 016 375 A1). Ferner ist bekannt, dass diese Membranen über Einwirkung von elektromagnetischer Strahlung (z.B. eines Lasers) strukturiert werden können (siehe z.B. DE 10 2012 016 378 A1).

Die US 2016/199561 A1 offenbart eine Vorrichtung, die eine mehrschichtige Membran mit mehreren Schichten, ein elektroaktives Polymer in jeder Schicht und eine Steuereinheit umfasst, die betriebsmäßig so angeschlossen ist, dass er das elektroaktive Polymer nacheinander aktiviert, um eine oder mehrere Größen der Vielzahl der Poren mit unterschiedlicher Größe in einer oder mehreren Schichten der mehrschichtigen Membran zu verändern. Zudem wird eine Vorrichtung offenbart, die Membran mit mehreren Schichten, einen Aktuator, der betriebsmäßig mit den mehreren Schichten verbunden ist, und eine Steuereinheit umfasst, die den Aktuator betriebsmäßig aktiviert, um eine relative seitliche Position der Schichten der mehrschichtigen Membran zu ändern und so mindestens zwei Poren innerhalb der Schichten der Membran auszurichten.

Ausgehend hiervon war es die Aufgabe der vorliegenden Erfindung, eine Vorrichtung und ein Verfahren zur Separation von Partikeln in einer Flüssigkeit bereitzustellen, das die Nachteile aus dem Stand der Technik nicht aufweist. Insbesondere sollte es mit der Vorrichtung und dem Verfahren möglich sein, nicht nur unterschiedlich große Partikel (z.B. unterschiedliche große biologische Zellen und/oder Endosomen) einer Flüssigkeit mit einer hohen Trennschärfe voneinander zu trennen, sondern auch gleich große Partikel (z.B. B-Zellen und T-Zellen) voneinander zu trennen. Die voneinander separierten Partikel sollten auf eine einfache, schnelle und kostengünstige Art und Weise und auch bei kleinen Flüssigkeitsvolumina in einer hohen Ausbeute bereitgestellt werden können. Zudem sollten die Partikel in einer therapeutisch verwendbaren Flüssigkeit bereitgestellt werden können. Darüber hinaus sollten Verwendungen der Vorrichtung vorgeschlagen werden.

Die Aufgabe wird gelöst durch die Vorrichtung mit den Merkmalen von Anspruch 1, dem Kit mit den Merkmalen von Anspruch 12, dem Verfahren mit den Merkmalen von Anspruch 13 und der Verwendung mit den Merkmalen von Anspruch 15. Die abhängigen Ansprüche zeigen vorteilhafte Weiterbildungen auf. Erfindungsgemäß wird eine Vorrichtung zur Separation von Partikeln in einer Flüssigkeit, enthaltend
a) einen Behälter zur Aufnahme einer Flüssigkeit (Suspension),
b) ein flächiges Filterelement mit einer Oberseitenfläche und einer Unterseitenfläche,

wobei das Filterelement durchgängige Poren mit einem definierten Porendurchmesser aufweist,
wobei das Filterelement in dem Behälter dergestalt angeordnet ist, dass es den Behälter in Richtung Oberseitenfläche des Filterelements in ein oberes Kompartiment und in Richtung Unterseitenfläche des Filterelements in ein unteres Kompartiment aufteilt, sodass Partikel einer Flüssigkeit im oberen Kompartiment nur dann in das untere Kompartiment gelangen können, wenn sie das Filterelement passieren, wobei das obere Kompartiment des Behälters eine Öffnung zur Aufnahme einer Flüssigkeit mit Partikeln aufweist,
wobei das obere Kompartiment des Behälters mindestens eine Gruppe von Festphase-Partikeln enthält, die einen bestimmten hydrodynamischen Durchmesser aufweisen und die mindestens ein Molekül an ihrer Oberfläche exponieren, das dazu geeignet ist, spezifisch an ein Oberflächenmolekül einer ersten Partikelart zu binden, und
wobei das Filterelement ein Material enthält oder daraus besteht, das dazu geeignet ist, durch Anlegen einer elektrische Spannung an das Filterelement und/oder durch Einwirken einer mechanischen Kraft auf das Filterelement den Porendurchmesser seiner Poren zu verändern,
wobei die Vorrichtung eine elektrische Spannungsquelle aufweist;
wobei die Vorrichtung mindestens zwei elektrisch leitfähige Schichten aufweist, die mit der elektrischen Spannungsquelle verbunden sind,
wobei mindestens eine der mindestens zwei elektrisch leitfähigen Schichten mindestens eine elektrische Isolationsschicht kontaktiert, die zwischen der mindestens einen elektrisch leitfähigen Schicht und dem Filterelement angeordnet ist,
dadurch gekennzeichnet, dass das Filterelement dazu geeignet ist, den Porendurchmesser seiner durchgängigen Poren durch Einwirkung einer elektrischen Spannung an das Filterelement und/oder durch Einwirken einer mechanischen Kraft auf das Filterelement in einem Bereich von 10 bis 200 µm zu verändern, wobei mindestens eine der mindestens zwei elektrisch leitfähigen Schichten ein Polymer und elektrisch leitfähige Partikel enthält.

Mit dem Begriff "durchgängige Poren" sind Poren gemeint, die sich von der Oberseite des Filterelements bis zur Unterseite des Filterelements erstrecken. Mit dem Begriff "mit einem definierten Porendurchmesser" ist gemeint, dass sich die Porendurchmesser aller Poren des Filterelements um weniger als 10 µm, bevorzugt weniger als 5 µm, voneinander unterscheiden. Der Begriff "Festphase-Partikel" umfasst auch "Gel-Partikel".

Mit der erfindungsgemäßen Vorrichtung ist es möglich, eine Trennung unterschiedlicher Partikel in einer Flüssigkeit (bzw- Suspension) in einer einzigen Vorrichtung durchzuführen. Ferner ist es möglich, durch die spezifische Ankopplung bestimmter Partikelarten der Flüssigkeit (z.B. Blutzellarten und/oder Vesikelarten in Blut) an Festphase-Partikel unterschiedlicher Größe, auch Partikel unterschiedlicher Art voneinander zu trennen, die eine im Wesentlichen gleiche Größe (d.h. einen im Wesentlichen gleichen hydrodynamischen Durchmesser) aufweisen. Die erfindungsgemäße Vorrichtung hat somit den Vorteil, dass nicht nur unterschiedlich große Partikel (z.B. unterschiedliche große biologische Zellen und/oder Endosomen) einer Flüssigkeit (Suspension) mit einer hohen Trennschärfe voneinander getrennt werden können, sondern auch gleich große Partikel (z.B. B-Zellen und T-Zellen) voneinander getrennt werden können. Die Trennung der gleich großen Partikel wird durch eine Kopplung der jeweiligen zu trennenden Partikelart an die Festphasen-Partikel erreicht, die der jeweiligen Partikelart eine definierte Partikelgröße "aufprägen". Die Vorrichtung erlaubt es zudem, voneinander separierte Partikel auf eine einfache, schnelle und kostengünstige Art und Weise und auch bei kleinen Flüssigkeitsvolumina in einer hohen Ausbeute breitzustellen. Dies liegt darin begründet, dass der Porendurchmesser des Filterelements der Vorrichtung variiert werden kann und somit kein sequenzielles Trennen der Partikel der Flüssigkeit in mehreren verschiedenen Vorrichtungen nötig ist, die jeweils Filterelemente mit unterschiedlichen, fixen Porendurchmessern enthalten. Ferner können die separierten Partikel in einer therapeutisch verwendbaren Flüssigkeit (beispielsweise ihrer Ursprungsflüssigkeit, z.B. Blutplasma) bereitgestellt werden.

Die erfindungsgemäße Vorrichtung kann als Membrankartusche ausgestaltet sein.

Die Vorrichtung kann dadurch gekennzeichnet sein, dass das obere Kompartiment des Behälters mindestens eine zweite Gruppe von Festphase-Partikeln mit einem zweiten hydrodynamischen Durchmesser enthält, wobei sich der zweite hydrodynamische Durchmesser von dem ersten hydrodynamischen Durchmesser unterscheidet und wobei die mindestens eine zweite Gruppe von Festphase-Partikeln ein Molekül an ihrer Oberfläche exponiert, das dazu geeignet ist, spezifisch an ein Oberflächenmolekül einer zweiten Partikelart zu binden. Diese Ausgestaltungsform hat den Vorteil, dass gezielt die nicht nur eine erste Partikelart von anderen Partikeln der Flüssigkeit, sondern auch eine zweite Partikelart von der ersten Partikelart und von anderen Partikeln der Flüssigkeit getrennt werden kann.

Ferner kann die Vorrichtung dadurch gekennzeichnet sein, dass das obere Kompartiment des Behälters mindestens eine dritte Gruppe von Festphase-Partikel mit einem dritten hydrodynamischen Durchmesser enthält, wobei sich der dritte hydrodynamische Durchmesser von dem ersten und zweiten hydrodynamischen Durchmesser unterscheidet und wobei die dritte Gruppe von Festphase-Partikel ein Molekül an ihrer Oberfläche exponiert, das dazu geeignet ist, spezifisch an ein Oberflächenmolekül einer dritten Partikelart zu binden. Bevorzugt enthält das obere Kompartiment eine vierte, fünfte, sechste, siebte, achte, neunte und/oder zehnte Gruppe von Festphase-Partikel mit jeweils einem hydrodynamischen Durchmesser, der sich von anderen Gruppen an Festphase-Partikel in dem oberen Kompartiment unterscheidet und wobei die Festphase-Partikel der jeweiligen Gruppen ein Molekül an ihrer Oberfläche exponieren, das dazu geeignet ist, spezifisch an ein Oberflächenmolekül einer jeweilig anderen Partikelart zu binden. Vorteil an dieser Ausgestaltungsform ist, dass mindestens drei Gruppen von Partikeln in einer Flüssigkeit selektiv voneinander und von anderen Partikeln der Flüssigkeit separiert werden können.

Das mindestens eine Molekül, das an der Oberfläche der Festphase-Partikel exponiert ist und dazu geeignet ist, spezifisch an ein Oberflächenmolekül einer ersten Partikelart zu binden, kann eine Polypeptidkette enthalten oder daraus bestehen, wobei die Polypeptidkette bevorzugt ausgewählt ist aus der Gruppe bestehend aus Antikörper, Antikörper-Fragment und Derivaten hiervon, besonders bevorzugt ausgewählt ist aus der Gruppe bestehend aus Fab-Fragment oder Derivat hiervon.

Ferner kann dieses Molekül ein Polynukleotid enthalten oder daraus bestehen, wobei das Polynukleotid bevorzugt ausgewählt ist aus der Gruppe bestehend aus DNA, RNA und Derivaten hiervon.

Darüber hinaus kann dieses Molekül ein Oligosaccharid enthalten oder daraus bestehen.

Es ist bevorzugt, dass dieses Molekül über nicht-kovalente Wechselwirkungen reversibel an der Oberfläche der Festphase-Partikel gebunden ist, bevorzugt dergestalt, dass die Bindung lösbar ist über eine Maßnahme ausgewählt aus der Gruppe bestehend aus Veränderung einer Konzentration einer Substanz, Veränderung einer Temperatur, Veränderung des pH-Werts und Kombinationen hiervon.

Ferner ist es bevorzugt, dass dieses Molekül dazu geeignet ist, spezifisch an ein Oberflächenmolekül einer Partikelart zu binden, die einen kleineren hydrodynamischen Durchmesser als die Festphase-Partikel aufweist, bevorzugt einen hydrodynamischen Durchmesser, der maximal 10%, bevorzugt maximal 8%, besonders bevorzugt maximal 6%, ganz besonders bevorzugt maximal 4%, insbesondere maximal 2%, des hydrodynamischen Durchmesser der Festphase-Partikel beträgt.

Die Vorrichtung kann mindestens zwei elektrisch leitfähige Schichten aufweisen, die mit einer elektrischen Spannungsquelle, bevorzugt mit einer elektrischen Spannungsquelle der Vorrichtung, verbunden sind.

Mindestens eine der mindestens zwei elektrisch leitfähigen Schichten kann auf der Oberseite des Filterelements aufgebracht sein oder auf der Unterseite des Filterelements aufgebracht sein. Bevorzugt eine der beiden elektrisch leitfähigen Schichten auf der Oberseite des Filterelements aufgebracht und die andere der beiden elektrisch leitfähigen Schichten auf der Unterseite des Filterelements aufgebracht.

Die Filtermembran kann eine elektrisch isolierende Schicht darstellen. Eine elektrische Isolationsschicht zu den mindestens zwei elektrisch leitfähigen Schichten kann dann unnötig sein.

Erfindungsgemäß kontaktiert mindestens eine der mindestens zwei elektrisch leitfähigen Schichten, optional die mindestens zwei elektrisch leitfähigen Schichten, mindestens eine elektrische Isolationsschicht, die zwischen der mindestens einen elektrisch leitfähigen Schicht und dem Filterelement angeordnet ist, wobei optional die mindestens zwei elektrisch leitfähigen Schichten jeweils mindestens eine elektrische Isolationsschicht kontaktieren, die zwischen den mindestens zwei elektrisch leitfähigen Schichten und dem Filterelement angeordnet ist. In dieser erfindungsgemäßen Ausgestaltungsform kann verhindert werden, dass zwischen der ersten und der weiteren elektrisch leitfähigen Schicht ein elektrischer Kurzschluss oder ein kurzzeitiger Überschlag entsteht. Die elektrische Isolationsschicht kann nur auf einer Seite des Filterelements (d.h. dessen Oberseite oder Unterseite) angeordnet sein oder es kann auf beiden Seiten des Filterelements eine elektrische Isolationsschicht angeordnet sein.

Darüber hinaus kann mindestens eine der mindestens zwei elektrisch leitfähigen Schichten, optional die mindestens zwei elektrisch leitfähigen Schichten, in einem Randbereich der Poren des Filterelements angeordnet sein. Diese Anordnung kann punktuell um die Poren des Filterelements ausgestaltet sein.

Ferner kann mindestens eine der mindestens zwei elektrisch leitfähigen Schichten, optional die mindestens zwei elektrisch leitfähigen Schichten, vollständig um die Poren des Filterelements angeordnet sein. In diesem Fall weist die elektrisch leitfähige Schicht an gleichen Stellen wie das Filterelement durchgängige Poren mit einem definierten Porendurchmesser auf.

Erfindungsgemäß enthält mindestens eine der mindestens zwei elektrisch leitfähigen Schichten, optional die mindestens zwei elektrisch leitfähigen Schichten, ein Polymer, optional ein elektrisch leitfähiges Polymer.

Zudem enthält mindestens eine der mindestens zwei elektrisch leitfähigen Schichten, optional die mindestens zwei elektrisch leitfähigen Schichten, erfindungsgemäß elektrisch leitfähige Partikel, bevorzugt Kohlenstoffpartikel, besonders bevorzugt einwandige oder mehrwandige Kohlenstoffnanoröhren. Optional liegt hierbei der Anteil der elektrisch leitfähigen Partikel im Bereich von 0,001 bis 30 Gew.-%, bevorzugt im Bereich von 0,01 bis 3 Gew.-%, bezogen auf das Gesamtgewicht der elektrisch leitfähigen Schicht. Vorteil an dieser Ausgestaltungsform ist, dass die elektrisch leitfähige Schicht auch dann elektrisch leitfähig ist, wenn sie (hauptsächlich) aus einem nicht-elektrisch leitfähigen Polymer besteht.

Ferner kann mindestens eine der mindestens zwei elektrisch leitfähigen Schichten, optional die mindestens zwei elektrisch leitfähige Schichten, ein Metall enthalten, wobei das Metall bevorzugt an der Oberfläche der elektrisch leitfähigen Schicht angeordnet ist. Enthält sie ein Metall, kann dieses in Form von Partikeln vorliegen.

Es ist bevorzugt, dass mindestens eine der mindestens zwei elektrisch leitfähigen Schichten, optional die mindestens zwei elektrisch leitfähigen Schichten, kraftschlüssig und/oder stoffschlüssig mit dem Filterelement oder einer elektrisch isolierenden Schicht verbunden ist/sind.

Mindestens eine der mindestens zwei elektrisch leitfähigen Schichten, optional die mindestens zwei elektrisch leitfähigen Schichten, kann/können über ein Verfahren ausgewählt aus der Gruppe bestehend aus Tampondruck, Rakeln, Siebdruck, Inkjet-Printing, Jetten, Sprühen, Bedampfen und Kombinationen hiervon, optional kombiniert mit einem Laser-Strukturierungsverfahren, auf das Filterelement oder auf eine elektrisch leitfähige Schicht aufgebracht sein.

Erfindungsgemäß weist die Vorrichtung eine elektrische Spannungsquelle auf, die elektrisch leitfähig mit mindestens zwei elektrisch leitfähigen Schichten der Vorrichtung verbunden ist, bevorzugt mit mindestens zwei elektrisch leitfähigen Schichten, die auf der Oberseite und/oder auf der Unterseite des Filterelements aufgebracht sind, der Vorrichtung verbunden ist. Vorteil hierbei ist, dass der Porendurchmesser der Poren des Filterelements über Anlegen einer elektrischen Spannung an das Filterelement verändert werden kann.

In einer weiteren, bevorzugten Ausgestaltungsform weist die Vorrichtung ein Mittel auf, das dazu geeignet ist, durch Einwirken einer mechanischen Kraft auf das Filterelement den Porendurchmesser seiner Poren zu verändern, wobei das Mittel ausgewählt ist aus der Gruppe bestehend aus Stempel zur Ausübung eines Drucks auf das Filterelement, pneumatische Vorrichtung zur Ausübung eines Drucks auf das Filterelement, Bi-Metall-Draht zur Ausübung eines Drucks auf das Filterelement, NiTiCu-Legierung zur Ausübung eines Drucks auf das Filterelement und Kombinationen hiervon. Vorteil hierbei ist, dass der Porendurchmesser der Poren des Filterelements über Einwirken einer mechanischen Kraft auf das Filterelement verändert werden kann.

Die Vorrichtung kann ein Mittel aufweisen, das dazu geeignet ist, an der Oberseitenfläche des Filterelements einen oszillierenden Fluidstrom anzulegen, bevorzugt einen Fluidstrom, der in einer Richtung senkrecht zur Oberseitenfläche des Filterelements oszilliert. Vorteil hierbei ist, dass eine mögliche Verstopfung des Filterelements während der Separation der Partikel verhindert wird.

Ferner kann die Vorrichtung eine Steuereinheit aufweisen, die konfiguriert ist, eine elektrische Spannung einer Spannungsquelle und/oder eine mechanische Kraft auf das Filterelement zu steuern.

Die Steuerung über die Steuereinheit erfolgt bevorzugt dergestalt, dass eine elektrische Spannung und/oder eine mechanische Kraft auf das Filterelement im Laufe einer Separation von Partikeln in einer Flüssigkeit stufenweise verändert wird, wobei die Veränderung bevorzugt automatisch im Laufe der Zeit oder manuell durch Eingabe eines Benutzers erfolgt. Insbesondere handelt es sich bei der Veränderung der elektrischen Spannung um eine Verringerung der elektrischen Spannung und bei der Veränderung der mechanischen Kraft auf das Filterelement um eine Erhöhung der mechanischen Kraft auf das Filterelement. Ziel ist in diesem Fall die Porenweite entsprechend aufzuweiten.

Ferner kann die Steuerung über die Steuereinheit dergestalt erfolgen, dass der Porendurchmesser der Poren des Filterelements in einem Bereich von 10 bis 200 µm, bevorzugt in einem Bereich von 20 bis 180 µm, besonders bevorzugt in einem Bereich von 30 bis 160 µm, insbesondere in einem Bereich von 40 bis 120 µm, verändert wird.

Abgesehen davon kann die Steuerung über die Steuereinheit dergestalt erfolgen, dass der Porendurchmesser der Poren des Filterelements automatisch im Laufe der Zeit oder manuell durch Eingabe(n) von einem Benutzer der Vorrichtung schrittweise auf einen größeren Porendurchmesser verändert wird, bevorzugt in Schritten von 5 bis 15 µm, besonders bevorzugt in Schritten von 9 bis 11 µm, ganz besonders bevorzugt von einem Porendurchmesser von 10 µm bis zu einem Porendurchmesser von 200 µm, insbesondere von einem Porendurchmesser von 40 µm über einen Porendurchmesser von 50 µm, einen Porendurchmesser von 60 µm, einem Porendurchmesser von 70 µm, einem Porendurchmesser von 80 µm, einem Porendurchmesser von 90 µm, einem Porendurchmesser von 100 µm, einem Porendurchmesser von 110 µm bis zu einem Porendurchmesser von 120 µm. Ein Vorteil einer DEA-Membran als Filterelement ist, dass die Porenweite nicht unbedingt auf vorgegebene Stufen begrenzt ist, sondern sich durch eine elektrische Spannung und/oder eine mechanische Kraft stufenlos verändern lässt.

Die Vorrichtung kann ein Mittel aufweisen, das dazu geeignet ist, die Flüssigkeit mit Partikeln durch das Filterelement zu bewegen.

Bevorzugt enthält dieses Mittel einen Stempel, der flüssigkeitsdicht und beweglich in dem ersten Kompartiment des Behälters angeordnet ist, oder besteht daraus. Vorteil hierbei ist, dass ein Benutzer über ein Bewegen des Stempels manuell die Beförderung der Flüssigkeit durch das Filterelement steuern kann.

Ferner kann dieses Mittel eine Fördereinrichtung, bevorzugt eine Pumpe, besonders bevorzugt eine Pumpe, die dazu konfiguriert ist, eine Flüssigkeit mit Partikeln bidirektional durch das Filterelement zu bewegen, enthalten oder daraus bestehen. Vorteil hierbei ist, dass ein Benutzer die Beförderung der Flüssigkeit durch das Filterelement über ein Einstellen einer Pumpenaktivität entweder manuell steuern kann oder automatisch (über eine Steuereinheit der Vorrichtung) steuern lassen kann.

Das Filterelement kann ein Material enthalten oder daraus bestehen, das elektroaktiv ist. Ferner kann das Filterelement ein Material enthalten oder daraus bestehen, das piezoelektrisch ist. Darüber hinaus kann das Filterelement ein Material enthalten oder daraus bestehen, das dielektrisch ist. Das Filterelement kann ein dielektrischer Elastomeraktor (DEA) sein. Vorteil an diesen Materialien bzw. am DEA ist, dass die Einstellung des Porendurchmessers des Filterelements über eine Veränderung einer an das Filterelement angelegten elektrischen Spannung erfolgen kann, wobei sich die Form der Querschnittsfläche der Poren durch die Veränderung ihres Durchmessers nicht wesentlich bzw. gar nicht ändert (z.B. bleibt die Form des Querschnitts kreisförmig). Dadurch kann die Selektivität des Filterelements präziser eingestellt werden als mit anderen Filterelementen, bei denen sich durch Veränderung des Porendurchmessers auch die Form des Querschnitts der Poren verändert (z.B. von rechteckig zu rhombenförmig verändert oder von kreisförmig nach oval verändert). Das Funktionsprinzip eines DEA beruht hierbei auf dem Maxwell-Spannungstensor, welcher sich zwischen zwei voneinander getrennten, gegensätzlich geladenen Elektroden ausbildet, ähnlich dem eines Kondensators. Beim Anlegen einer elektrischen Spannung entsteht ein Potentialunterschied zwischen den Elektroden, welcher zu einer mechanischen Spannung im Dielektrikum führt. Die Maxwell-Spannung sorgt für eine äqui-biaxiale, lineare Bewegung und erzielt somit die eigentliche Aktorwirkung, die zu einer Veränderung des Porendurchmessers der Poren des Filterelements führt.

Es ist bevorzugt, dass das Filterelement ein Material enthält oder daraus besteht, das elastisch ist. Ein solches Material erlaubt eine bessere Einstellung des Porendurchmessers durch Einwirken einer mechanischen Kraft auf das Filterelement. Auch für die Einstellung des Porendurchmessers über Anlegen einer elektrischen Spannung ist es vorteilhaft, wenn das Filterelement ein elastisches Material (z.B. ein Elastomer) enthält. Durch die stufenlose Einstellbarkeit der elektrischen Spannung kann somit auch die makro- oder mesoskopische Aktorwirkung beeinflusst werden. DEAs enthalten häufig ein inkompressibles Elastomer oder bestehen daraus. Folglich kann das Filterelement auch ein inkompressible Material enthalten oder daraus bestehen.

In einer bevorzugten Ausgestaltungsform enthält das Filterelement ein Polymer, bevorzugt ein Elastomer, besonders bevorzugt ein thermoplastisches Elastomer, oder besteht daraus. Insbesondere ist das Polymer ausgewählt aus der Gruppe bestehend aus Silikon-Elastomer, Flüssigkautschuk-Elastomer und Kombinationen hiervon.

Das Filterelement kann eine Ausdehnung von der Oberseite in Richtung Unterseite im Bereich von ≤ 250 µm, bevorzugt im Bereich von ≤ 200 µm, besonders bevorzugt im Bereich von ≤ 150 µm, insbesondere im Bereich von ≤ 100 µm, aufweisen. Vorteil an der geringen Dicke des Filterelements ist, dass die Vorrichtung leichter, kompakter und kostengünstiger bereitgestellt werden kann.

In einer bevorzugten Ausgestaltungsform ist das Filterelement vorgespannt, bevorzugt über eine äquibiaxiale Vordehnung im Bereich zwischen 50% und 150% vorgespannt. Die Vorspannung kann über eine Verbindung des Filterelements mit einem festen Rahmen der Vorrichtung sein. Vorteil an der Vorspannung ist, dass die ursprüngliche Porengröße der Poren des Filterelements, d.h. der Porendurchmesser der Poren des Filterelements in einem ungespannten Zustand (Entspannungszustand) kleiner ausfallen kann als eine Porengröße, die für die Durchführung eines Verfahrens zur Separation von Partikeln in einer Flüssigkeit gebraucht wird. Dies kann die Herstellungskosten des Filterelements reduzieren.

In einer bevorzugten Ausgestaltungsform weist das Filterelement durchgängige Poren auf, die einen im Wesentlichen runden Querschnitt haben. Dies ist vorteilhaft, wenn die Festphase-Partikel im oberen Kompartiment der Vorrichtung eine Kugelform aufweisen (was bevorzugt ist), da somit die über die Poren bereitgestellte Öffnung definiert auf den Kugeldurchmesser der Festphase-Partikel abgestimmt werden kann.

Das Filterelement ist erfindungsgemäß dazu geeignet, den Porendurchmesser seiner durchgängigen Poren durch Einwirkung einer elektrischen Spannung an das Filterelement und/oder durch Einwirken einer mechanischen Kraft auf das Filterelement in einem Bereich von 10 bis 200 µm, bevorzugt in einem Bereich von 20 bis 180 µm, besonders bevorzugt in einem Bereich von 30 bis 160 µm, ganz besonders bevorzugt in einem Bereich von 40 bis 120 µm, zu verändern. Insbesondere ist die Eignung dergestalt, dass die Veränderung des Porendurchmessers isotrop in alle Richtungen entlang einer Querschnittsfläche der Poren erfolgt.

Die zu separierenden Partikel können ausgewählt sein aus der Gruppe bestehend aus Vesikeln und biologischen Zellen, bevorzugt ausgewählt aus der Gruppe bestehend aus Vesikeln und biologischen Zellen aus Blut, besonders bevorzugt ausgewählt aus der Gruppe bestehend aus endosomalen Vesikeln, exosomalen Vesikeln, Thrombocyten, Erythrocyten, Leukocyten und Kombinationen hiervon.

Die Festphase-Partikel, die dazu geeignet sind, spezifisch an ein Oberflächenmolekül einer ersten Partikelart der zu separierenden Partikel zu binden, können ein Polymer enthalten oder daraus bestehen, wobei das Polymer bevorzugt ausgewählt ist aus der Gruppe bestehend aus Kunststoff, Agarose und Kombinationen hiervon.

Die Festphase-Partikel können Festphase-Kügelchen sein und bevorzugt eine im Wesentlichen runde Form (Kugelform) aufweisen. Die (im Wesentlichen) runde Form ist vorteilhaft, da die Festphase-Partikel somit in alle Ausdehnungsrichtungen eine (im Wesentlichen) gleiche räumliche Ausdehnung (d.h. den gleichen Durchmesser) aufweisen und somit ihre Eignung, eine Pore mit einem definierten Porendurchmesser zu passieren, genauer vorhergesagt werden kann und exakter definiert ist.

Ferner wird erfindungsgemäß ein Kit bereitgestellt, der eine erfindungsgemäße Vorrichtung enthält und ein Gerät enthält, und ein das mindestens eines, bevorzugt alle, der folgenden Mittel aufweist:
ein Mittel, das dazu geeignet ist, eine elektrische Spannung an das Filterelement anzulegen, wobei das Mittel bevorzugt eine elektrische Spannungsquelle enthält oder daraus besteht;
ein Mittel, das dazu geeignet ist, an der Oberseitenfläche des Filterelements einen oszillierenden Fluidstrom anzulegen, bevorzugt einen Fluidstrom, der in einer Richtung senkrecht zur Oberseitenfläche des Filterelements oszilliert; und
ein Mittel, das dazu geeignet ist, die Flüssigkeit mit Partikeln durch das Filterelement zu bewegen, wobei das Mittel bevorzugt ausgewählt ist aus der Gruppe bestehend aus Stempel, der flüssigkeitsdicht und beweglich in dem ersten Kompartiment des Behälters angeordnet ist, eine Fördereinrichtung, bevorzugt eine Pumpe, besonders bevorzugt eine Pumpe, die dazu konfiguriert ist, eine Flüssigkeit mit Partikeln bidirektional durch das Filterelement zu bewegen, und Kombinationen hiervon.

Darüber hinaus wird ein Verfahren zur Separation von Partikeln in einer Flüssigkeit bereitgestellt, umfassend die Schritte
a) Bereitstellen mindestens einer Gruppe von Festphase-Partikeln, die einen bestimmten hydrodynamischen Durchmesser aufweisen und die mindestens ein Molekül an ihrer Oberfläche exponieren, das dazu geeignet ist, spezifisch an ein Oberflächenmolekül einer ersten Partikelart der Partikel der Flüssigkeit zu binden;
b) Inkubieren der Flüssigkeit mit der mindestens einen Gruppe von Festphase-Partikeln, bis die Festphase-Partikel der mindestens einen Gruppe von Festphase-Partikeln spezifisch an ein Oberflächenmolekül einer ersten Partikelart der Partikel der Flüssigkeit gebunden haben;
c) Bereitstellen eines Filterelements, das ein Material enthält oder daraus besteht, das dazu geeignet ist, durch Anlegen einer elektrischen Spannung an das Filterelement und/oder durch Einwirken einer mechanischen Kraft auf das Filterelement den Porendurchmesser seiner Poren zu verändern;
d) Einstellen des Porendurchmessers der Poren des Filterelements über Anlegen einer elektrischen Spannung an das Filterelement und/oder Einwirken einer mechanischen Kraft auf das Filterelement, sodass nur Partikel bis zu einem gewünschten Partikeldurchmesser das Filterelement passieren können, wobei der eingestellte Partikeldurchmesser kleiner ist wie ein hydrodynamischer Durchmesser von der mindestens einen Gruppe von Festphase-Partikeln;
e) Bewegen der Flüssigkeit durch das Filterelement;
f) Isolieren der Flüssigkeit;
g) Erhöhung des Porendurchmessers der Poren des Filterelements durch Verringerung der Stärke der elektrischen Spannung und/oder durch Erhöhung der mechanischen Kraft auf das Filterelement, sodass Partikel bis zu einem gewünschten, nun größeren Partikeldurchmesser das Filterelement passieren können, wobei es sich bevorzugt um die Partikel der ersten Partikelart handelt, die an die Gruppe von Festphase-Partikeln gebunden sind;
h) Optional Zugabe einer Flüssigkeit, die bevorzugt keine Partikel enthält, zu der Flüssigkeit mit den nicht passierten Partikeln;
i) Bewegen der Flüssigkeit durch das Filterelement;
j) Isolieren der Flüssigkeit, welche die Partikel der ersten Partikelart enthält;
k) Optional Wiederholen der Schritte g) bis j), bis alle Partikel der Flüssigkeit nach ihrer Größe separiert in getrennten Flüssigkeiten vorliegen.

Das Verfahren kann dadurch gekennzeichnet sein, dass es mit einer erfindungsgemäßen Vorrichtung durchgeführt wird.

Bevorzugt umfasst das Verfahren dann die folgenden Schritte:
i) Einstellen des Porendurchmessers der Poren des Filterelements der Vorrichtung über Anlegen einer elektrischen Spannung an das Filterelement und/oder über Einwirken einer mechanischen Kraft auf das Filterelement, sodass nur Partikel bis zu einem gewünschten Partikeldurchmesser das Filterelement passieren können, wobei der eingestellte Partikeldurchmesser kleiner ist als ein hydrodynamischer Durchmesser von der mindestens einen Gruppe von Festphase-Partikeln;
ii) Befüllen des oberen Kompartiments des Behälters der Vorrichtung mit einer Flüssigkeit, die Partikel mit einer unterschiedlichen Größe enthält;
iii) Inkubieren der Flüssigkeit im oberen Kompartiment des Behälters der Vorrichtung mit der mindestens einen Gruppe von Festphase-Partikeln, bis zumindest Festphase-Partikel der mindestens einen Gruppe von Festphase-Partikeln spezifisch an ein Oberflächenmolekül einer ersten Partikelart der Partikel (z.B. einer ersten Art von Blutpartikeln) gebunden haben;
iv) Bewegen der Flüssigkeit durch das Filterelement der Vorrichtung in das untere Kompartiment des Behälters;
v) Isolieren der Flüssigkeit mit den passierten Partikeln aus dem unteren Kompartiment des Behälters der Vorrichtung;
vi) Erhöhung des Porendurchmessers der Poren des Filterelements der Vorrichtung durch Verringerung der Stärke der elektrischen Spannung und/oder durch Erhöhung einer mechanischen Kraft auf das Filterelement, sodass Partikel bis zu einem gewünschten, nun größeren Partikeldurchmesser das Filterelement passieren können, wobei es sich bevorzugt um die Partikel der ersten Partikelart handelt, die an die Gruppe von Festphase-Partikel gebunden sind;
vii) Optional Befüllen des oberen Kompartiments des Behälters der Vorrichtung mit einer Flüssigkeit, die bevorzugt keine Partikel enthält;
viii) Bewegen der Flüssigkeit durch das Filterelement der Vorrichtung in das untere Kompartiment des Behälters;
ix) Isolieren der Flüssigkeit, welche die Partikel der ersten Partikelart enthält, aus dem unteren Kompartiment des Behälters der Vorrichtung;
x) Optional Wiederholen der Schritte vi) bis ix), bis alle Partikel der Flüssigkeit nach ihrer Größe separiert in getrennten Flüssigkeiten vorliegen.

Ferner wird die Verwendung der erfindungsgemäßen Vorrichtung und/oder des erfindungsgemäßen Kits, zur Separation von Partikeln unterschiedlicher Größe, die in einer Flüssigkeit vorliegen, vorgeschlagen. Die Verwendung kann eine Isolation von einer oder mehreren Blutzellfraktionen aus Blut, bevorzugt zur Bereitstellung der Blutzellfraktionen für die Diagnostik und/oder zur Herstellung von Blutpräparaten, insbesondere zur Erzeugung von Zelltherapeutika, betreffen. Zudem kann die Verwendung eine Isolation von Bakterienzellen aus Blut betreffen. Ferner kann die Verwendung eine Isolation von endosomalen oder exosomalen Vesikeln aus Blut, Blutserum oder Biosuspensionen, bevorzugt zur Bereitstellung von endosomalen Vesikeln für die Diagnostik und/oder zur Herstellung von Impfstoffen, betreffen. Abgesehen davon kann die Verwendung eine Isolation von Gewebezellen aus gemischten Gewebezellfraktionen betreffen. Darüber hinaus kann die Verwendung eine Isolation von Zellen aus gemischten Zellsuspensionen, die von Bioreaktoren stammen, betreffen, wobei die Zellen bevorzugt ausgewählt sind aus der Gruppe bestehend aus Pflanzenzellen, tierischen Zellen, menschlichen Zellen, Bakterienzellen, Hefezellen und Kombinationen hiervon.

Anhand der nachfolgenden Figuren und Beispiele soll der erfindungsgemäße Gegenstand näher erläutert werden, ohne diesen auf die hier dargestellten, spezifischen Ausführungsformen einschränken zu wollen.

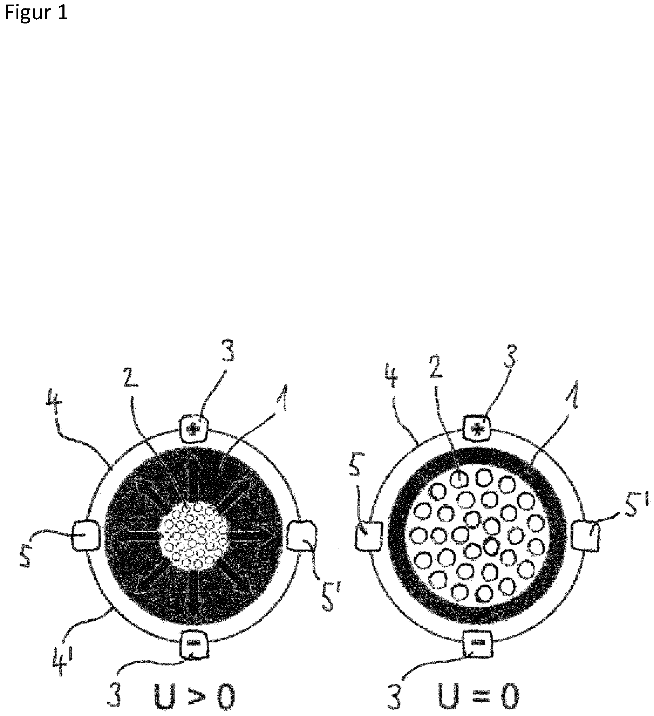

Figur 1 zeigt schematisch eine Einstellung der Porenweite eines Filterelements 1, das ein elektroaktives Material enthält oder daraus besteht. Wird an das Filterelement über zwei elektrisch leitfähige Schichten 4, 4', die sich an der Seitenwand einer Pore 2 des Filterelements befindet und durch eine Isolationsschicht 5 voneinander getrennt sind, durch eine elektrische Spannungsquelle 3 eine hohe elektrische Spannung (im kV-Bereich) angelegt, ziehen sich die Poren 2 des Filterelements 1 zusammen und der Porendurchmesser der Poren 2 ist verhältnismäßig klein. Wird die Spannung der elektrischen Spannungsquelle 3 auf Null reduziert, weiten sich die Poren 2 des Filterelements 1 zu einem maximalen Wert auf. Zwischen der hohen Spannung (z.B. einige kV) und dem Spannungswert Null lässt sich der Porendurchmesser der Poren 2 des Filterelements 1 gezielt und stufenlos einstellen.

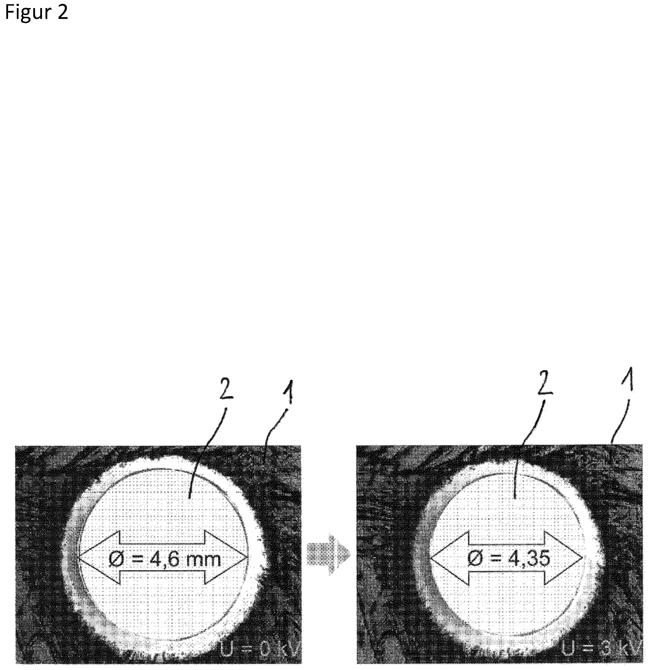

Figur 2 zeigt eine makroskopische Aufnahme einer Aufweitung einer einzelnen Pore 2 eines Filterelements 1, das ein elektroaktives Material enthält oder daraus besteht, in Abhängigkeit von der angelegten elektrischen Spannung. Hier ist das Filterelement eine DEA-Membran. Es ist erkennbar, dass sich der Porendurchmesser dieser Pore 2 von einem Durchmesser von 4,6 mm bei einer angelegten elektrischen Spannung von Null auf einen Porendurchmesser von 4,35 mm bei einer angelegten elektrischen Spannung von 3 kV (elektrisches Feld ist an das Filterelement angelegt) reduzieren lässt. Die erzielte Verkleinerung des Durchmessers der abgebildeten Pore 2 beträgt in diesem Fall ca. 250 µm.

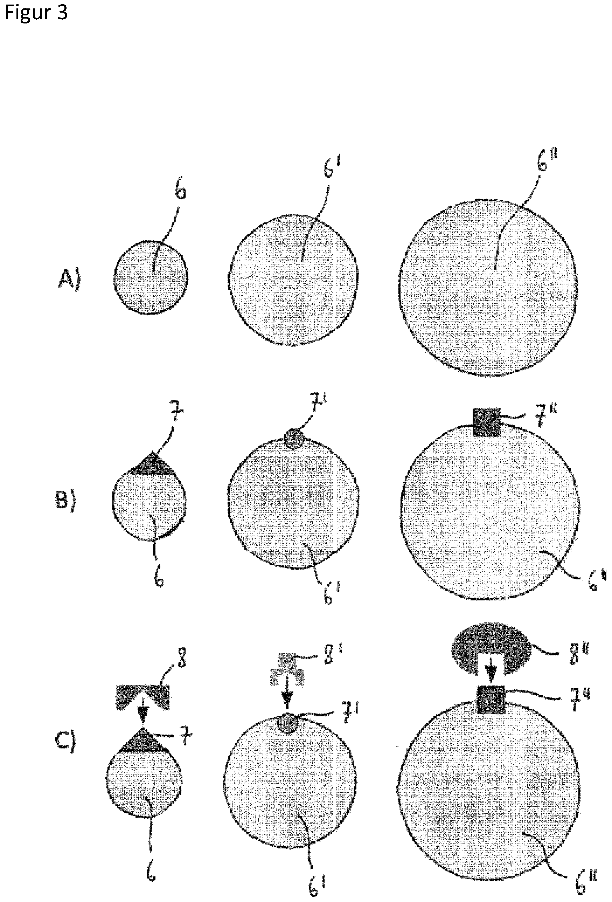

Figur 3 zeigt schematisch die Herstellung von drei Gruppen mit zueinander unterschiedlich großen Festphase-Partikel 6, 6', 6", wobei die Festphase-Partikel 6, 6', 6" jeder Gruppe jeweils ein spezifisches Bindungsmolekül 7, 7', 7" reversibel an der Oberfläche gebunden hat. In einem ersten Schritt werden drei Gruppen von Festphase-Partikel 6, 6', 6" bereitgestellt, die jeweils Festphase-Partikel 6, 6', 6" mit einem unter den Gruppen verschiedenen hydrodynamischen Radius aufweisen (Figur 3A). In einem zweiten Schritt erfolgt eine spezifische chemische Funktionalisierung der Oberfläche der Festphase-Partikel 6, 6', 6", sodass die Festphase-Partikel 6, 6', 6" jeder Gruppe ein bestimmtes Bindungsmolekül 7, 7', 7" an ihrer Oberfläche exponieren und sich das bestimmte Bindungsmolekül 7, 7', 7" unter den drei Gruppen unterscheidet (Figur 3B). In einem dritten Schritt erfolgt eine Anbindung von Partikeln 8, 8', 8" (z.B. Blutzellen) der Flüssigkeit, welche die zu trennenden Partikel 8, 8', 8" enthält, an die Festphase-Partikel 6, 6', 6" der jeweiligen Gruppen. Die Anbindung erfolgt dergestalt, dass jede der drei Gruppen von Festphase-Partikel 6, 6', 6" nur bestimmte Partikel 8, 8', 8" (z.B. bestimmte Blutzellen wie B-Zellen oder T-Zellen) bindet. Durch diese Maßnahme können auch gleich große Partikel 8, 8', 8" (wie z.B. B-Zellen und T-Zellen) voneinander getrennt werden, da sie an deutlich größere Festphase-Partikel 6, 6', 6" gebunden sind und diese den jeweiligen hydrodynamischen Radius der entstehenden Komplexe bestimmen. Es wird den gleich großen Partikeln 8, 8', 8" somit jeweils ein bestimmter hydrodynamischer Radius "aufgeprägt", der ihre Trenneigenschaften durch das Filterelement festlegt.

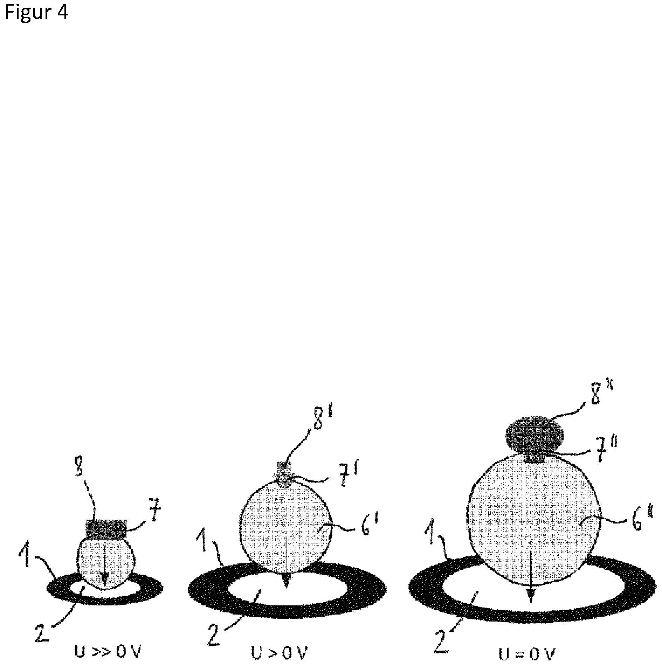

Figur 4 zeigt schematisch ein Durchdringen einer Pore 2 des Filterelements 1 von den jeweiligen Festkörper-Partikeln 6, 6', 6". Da die Festkörperpartikel 6, 6', 6" jeweils über ein bestimmtes Bindungsmolekül 7, 7', 7" an eine jeweilige Partikelart der zu trennenden Partikel 8, 8', 8" gebunden sind und einen deutlich größeren Durchmesser aufweisen als die zu trennenden Partikel 8, 8', 8", wird die Möglichkeit der zu trennenden Partikel 8, 8', 8", die Pore 2 des Filterelements 1 zu passieren, von dem Festkörperpartikel 6, 6', 6" bestimmt, an das sie gebunden sind. Wird an das Filterelement 1 eine hohe elektrische Spannung angelegt (linke Abbildung), ist der Porendurchmesser seiner Poren 2 relativ klein. Folglich können lediglich die Partikel 8 die Pore 2 passieren, die an die relativ kleinsten Festkörper-Partikel 6 gebunden sind. Wird an das Filterelement 1 eine niedrigere elektrische Spannung angelegt (mittlere Abbildung), wird der Porendurchmesser seiner Poren 2 größer. Folglich können nun die Partikel 8' die Pore 2 passieren, die an größere Festkörper-Partikel 6' gebunden sind. Wird an das Filterelement 1 keine elektrische Spannung angelegt (rechte Abbildung), stellt sich der Porendurchmesser seiner Poren 2 auf den größten Wert (Maximalwert) ein. Folglich können nun auch die Partikel 8" die Pore 2 passieren, die an die größten Festkörper-Partikel 6" gebunden sind.

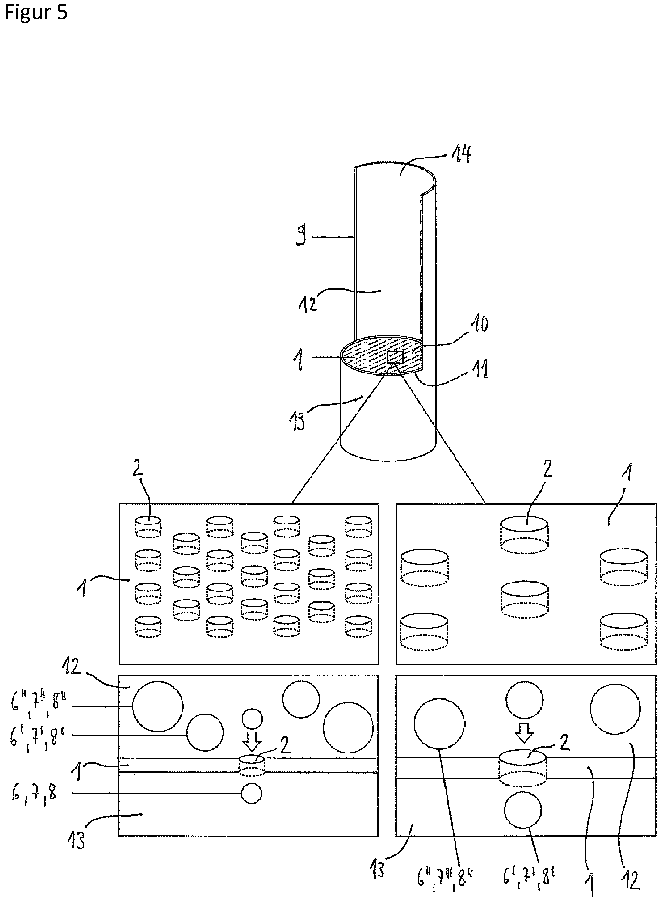

Figur 5 zeigt schematisch eine erfindungsgemäße Vorrichtung zur Separation von Partikeln in einer Flüssigkeit, die hier in Form einer Kartusche ausgestaltet ist. Die Vorrichtung enthält einen Behälter 9 zur Aufnahme einer Flüssigkeit (Suspension) und ein flächiges Filterelement 1 mit einer Oberseitenfläche 10 und einer Unterseitenfläche 11, wobei das Filterelement 1 durchgängige Poren 2 mit einem definierten Porendurchmesser aufweist. Das Filterelement 1 ist in dem Behälter 9 dergestalt angeordnet, dass es den Behälter 9 in Richtung Oberseitenfläche 10 des Filterelements 1 in ein oberes Kompartiment 12 mit einer Öffnung 14 und in Richtung Unterseitenfläche 11 des Filterelements 1 in ein unteres Kompartiment 13 aufteilt, sodass Partikel einer Flüssigkeit im oberen Kompartiment 12 nur dann in das untere Kompartiment 13 gelangen können, wenn sie das Filterelement 1 passieren, wobei das obere Kompartiment 12 des Behälters 9 eine Öffnung 14 zur Aufnahme einer Flüssigkeit mit Partikeln aufweist. Die Vorrichtung ist dadurch gekennzeichnet, dass das obere Kompartiment 12 des Behälters 9 mindestens eine Gruppe von Festphase-Partikeln 6, 6', 6" enthält, die einen bestimmten hydrodynamischen Durchmesser aufweisen und die mindestens ein Molekül 7, 7', 7" an ihrer Oberfläche exponieren (nicht separat dargestellt), das dazu geeignet ist, spezifisch an ein Oberflächenmolekül einer ersten Partikelart 8, 8', 8" (nicht separat dargestellt) zu binden. Das Filterelement 1 enthält ein Material oder besteht daraus, das dazu geeignet ist, durch Anlegen einer elektrische Spannung an das Filterelement 1 und/oder durch Einwirken einer mechanischen Kraft auf das Filterelement 1 den Porendurchmesser seiner Poren 2 zu verändern. Im unteren Teil von Figur 5 ist dargestellt, wie im Falle eines kleinen Porendurchmessers der Poren 2 des Filterelements 1 zunächst nur die kleineren Bindungskomplexe 6, 7, 8 die Poren 2 des Filterelements 1 passieren können und vom oberen Kompartiment 12 des Behälters 9 in das untere Kompartiment 13 des Behälters 9 gelangen können. Wird anschließend der Porendurchmesser der Poren 2 des Filterelements 1 durch Anlegen einer elektrischen Spannung und/oder Einwirken einer mechanischen Kraft vergrößert, können nun auch die größeren Bindungskomplexe 6', 7', 8' die Poren 2 des Filterelements passieren und vom oberen Kompartiment 12 des Behälters 9 in das untere Kompartiment 13 des Behälters gelangen.

### Beispiel 1 - Herstellung von geeigneten Festphase-Partikeln

Die in der Vorrichtung eingesetzten Festphase-Partikel können effektiv, schnell anpassbar, potentiell hochskalierbar und ressourcenschonend in Wasser-in-Öl-Emulsionen hergestellt werden.

Hierbei wird beispielsweise wasserbasierte Agarose in flüssiger Phase in eine Ölphase appliziert, wobei sich die Agarose zu Tröpfchen bzw. Beads verformt. Nach anschließender Polymerisierung der Agarose können die Beads gewaschen und funktionalisiert werden. Diese Methode ergibt Festphase-Partikel aus Agarose mit einer polydispersen Größenverteilung. Die Größenverteilung kann durch die Veränderung der Herstellungsparameter wie bspw. Agarose-zu-Öl-Verhältnis oder Öl-Viskosität präzise eingestellt werden.

Es ist vorteilhaft, wenn die erzeugten Festphase-Partikel eine Größenvariation von weniger als 10 µm aufweisen, also relativ homodispers sind. Ferner ist es vorteilhaft, wenn mehrere verschiedene Größenfraktionen an Festphase-Partikel erzeugt werden, wobei der Unterschied der mittleren Durchmesser der Festphase-Partikel zwischen den einzelnen Fraktionen bevorzugt mindestens 10 µm beträgt.

Beispielsweise werden Fraktionen bereitgestellt, bei denen die Festphase-Partikel innerhalb einer Fraktion eine Größenvariation von weniger als 10 µm aufweisen und bei denen der mittlere Durchmesser der Festphase-Partikel einer ersten Fraktion 40 µm, einer zweiten Fraktion 50 µm, einer dritten Fraktion 60 µm, einer vierten Fraktion 70 µm, einer fünften Fraktion 80 µm, einer sechsten Fraktion 90 µm, einer siebten Fraktion 100 µm, einer achten Fraktion 110 µm und einer neunten Fraktion 120 µm beträgt.

### Beispiel 2 - Anbindung eines Bindungsmoleküls an die Festphase-Partikel

Zur Anbindung eines bestimmten Moleküls, das dazu geeignet ist, spezifisch an ein Oberflächenmolekül einer ersten Partikelart zu binden, wird an die Festphase-Partikel (z.B. Agarose-Partikel) beispielsweise chemisch kovalent Strep-Tactin^{®} (z.B. über ein chemisches Kopplungsverfahren) gebunden. Als Bindungsmolekül kann beispielsweise ein Antikörperfragment (z.B. Fab-Fragment) verwendet werden, das chemisch kovalent einen Strep-tag^{®} gebunden hat (z.B. über mikrobiologische Produktion eines Proteins, das sowohl das Antikörperfragments als auch den Strep-tag^{®} enthält). Führt man nun die modifizierten Festphase-Partikel mit den modifizierten Antikörperfragmenten in einer wässrigen Lösung zusammen, binden beide über eine nicht-kovalente (und reversible) Strep-Tactin^{®}- Strep-tag^{®}-Bindung aneinander, d.h. ein Bindungskomplex entsteht.

Wird das Antikörperfragment so gewählt, dass es beispielsweise nur T-Zellen bindet, können T-Zellen über die Bindung an das Fab-Fragment, das wiederrum über die Strep-Tactin^{®}- Strep-tag^{®}-Bindung über nicht-kovalente Wechselwirkungen auf den Festphase-Partikel immobilisiert ist, an die Festphase-Partikel gebunden werden. Die nicht-kovalente Strep-Tactin^{®}- Strep-tag^{®}-Bindung ist reversibel und kann durch Einstellen einer bestimmten Biotin-Konzentration in der wässrigen Lösung getrennt werden. Anders ausgedrückt lassen sich nach der erfolgten Separation die an die Festphase-Partikel gebundenen T-Zellen über Biotinzugabe wieder von den Festphase-Partikeln trennen.

### Beispiel 3 - Herstellung einer Filtermembran mit selektiver Porengröße

Die Herstellung einer Membrane, die ein dielektrisches Elastomer enthält, ist im Stand der Technik bekannt (siehe z.B. DE 10 2012 016 375 A1). Solche Membranen können zur Herstellung eines Filterelements verwendet werden, wie es im erfindungsgemäßen Verfahren und der erfindungsgemäßen Vorrichtung zum Einsatz kommt.

Es ist zudem bekannt, dass sich solche Membranen über Einwirkung von elektromagnetischer Strahlung (z.B. eines Lasers) strukturieren lassen (siehe z.B. DE 10 2012 016 378 A1).

Um eine für die erfindungsgemäße Vorrichtung und das erfindungsgemäße Verfahren geeignete Filtermembran herzustellen, wird beispielsweise in eine Filtermembran, die ein dielektrisches Polymer enthält oder daraus besteht, ein Array durchgängiger Poren mit einem definierten Porendurchmesser eingebracht. Mit Poren mit einem "definierten" Porendurchmesser ist gemeint, dass der Porendurchmesser aller Poren des Filterelements weniger als 10 µm, bevorzugt weniger als 5 µm, variiert. Poren mit diesen Anforderungen können beispielsweise über eine elektromagnetische Strahlung eines Lasers in die Filtermembran eingefügt werden.

### Beispiel 4 - Verfahren zur Separation von Partikeln in einer Flüssigkeit

In einem ersten Schritt werden verschiede Fraktionen von verschieden großen Festphase-Partikeln hergestellt (z.B. gemäß Beispiel 1).

In einem zweiten Schritt werden diese jeweils mit den unterschiedlichen, zellspezifischen Bindungsmolekülen funktionalisiert (z.B. gemäß Beispiel 2).

In einem dritten Schritt wird eine Filtermembran zur Separation der Partikel bereitgestellt (z.B gemäß Beispiel 3).

In einem vierten Schritt werden die unterschiedlich großen Festphase-Partikel (z.B. Agarose-Partikel) mit einer Flüssigkeit kontaktiert, welche die zu separierenden Partikel (z.B. Blutzellen und Vesikel aus Blut) enthält. Dabei binden bestimmte Partikelarten (z.B. bestimmte Blutzellen) spezifisch an Festphase-Partikel einer bestimmten Größe, wodurch diesen die Größe der Festphasen-Partikel auferlegt ("aufgeprägt") wird.

In einem fünften Schritt werden die an die jeweiligen Festphasen-Partikel gebundenen Partikel (z.B. Blutzellen) stufenweise, beginnend mit der kleinsten Fraktion der Festphase-Partikel, über die Filtermembran getrennt, wobei hierfür der Porendurchmesser der Filtermembran stufenweise vergrößert wird.

### Bezugszeichenliste

- 1:: Filterelement;
- 2:: Pore des Filterelements;
- 3:: elektrische Spannungsquelle;
- 4, 4':: elektrisch leitfähige Schicht;
- 5, 5':: Isolationsschicht;
- 6, 6', 6":: Festphase-Partikel;
- 7, 7', 7":: Bindungsmolekül;
- 8, 8', 8":: zu trennendes Partikel der Lösung (Suspension).

## Patentansprüche

1. Vorrichtung zur Separation von Partikeln (8, 8', 8") in einer Flüssigkeit, enthaltend
a) einen Behälter zur Aufnahme einer Flüssigkeit (Suspension),
b) ein flächiges Filterelement (1) mit einer Oberseitenfläche und einer Unterseitenfläche,
wobei das Filterelement (1) durchgängige Poren (2) mit einem definierten Porendurchmesser aufweist,
wobei das Filterelement (1) in dem Behälter dergestalt angeordnet ist, dass es den Behälter in Richtung Oberseitenfläche des Filterelements (1) in ein oberes Kompartiment und in Richtung Unterseitenfläche des Filterelements (1) in ein unteres Kompartiment aufteilt, sodass Partikel (8, 8', 8") einer Flüssigkeit im oberen Kompartiment nur dann in das untere Kompartiment gelangen können, wenn sie das Filterelement (1) passieren, wobei das obere Kompartiment des Behälters eine Öffnung zur Aufnahme einer Flüssigkeit mit Partikeln (8, 8', 8") aufweist,
wobei das obere Kompartiment des Behälters mindestens eine Gruppe von Festphase-Partikeln (6, 6', 6") enthält, die einen bestimmten hydrodynamischen Durchmesser aufweisen und die mindestens ein Molekül (7, 7', 7") an ihrer Oberfläche exponieren, das dazu geeignet ist, spezifisch an ein Oberflächenmolekül einer ersten Partikelart (8) zu binden,
wobei das Filterelement (1) ein Material enthält oder daraus besteht, das dazu geeignet ist, durch Anlegen einer elektrische Spannung an das Filterelement (1) und/oder durch Einwirken einer mechanischen Kraft auf das Filterelement (1) den Porendurchmesser seiner Poren (2) zu verändern,
wobei die Vorrichtung eine elektrische Spannungsquelle (3) aufweist; wobei die Vorrichtung mindestens zwei elektrisch leitfähige Schichten (4, 4') aufweist, die mit der elektrischen Spannungsquelle (3) verbunden sind,
wobei mindestens eine der mindestens zwei elektrisch leitfähigen Schichten (4, 4') mindestens eine elektrische Isolationsschicht (5, 5') kontaktiert, die zwischen der mindestens einen elektrisch leitfähigen Schicht (4, 4') und dem Filterelement (1) angeordnet ist,
**dadurch gekennzeichnet, dass** das Filterelement (1) dazu geeignet ist, den Porendurchmesser seiner durchgängigen Poren (2) durch Einwirkung einer elektrischen Spannung an das Filterelement (1) und/oder durch Einwirken einer mechanischen Kraft auf das Filterelement (1) in einem Bereich von 10 bis 200 µm zu verändern,
wobei mindestens eine der mindestens zwei elektrisch leitfähigen Schichten (4, 4') ein Polymer und elektrisch leitfähige Partikel enthält.

2. Vorrichtung gemäß Anspruch 1, **dadurch gekennzeichnet, dass** das obere Kompartiment des Behälters mindestens eine zweite Gruppe von Festphase-Partikeln (6, 6', 6") mit einem zweiten hydrodynamischen Durchmesser enthält, wobei sich der zweite hydrodynamische Durchmesser von dem ersten hydrodynamischen Durchmesser unterscheidet und wobei die mindestens eine zweite Gruppe von Festphase-Partikeln (6, 6', 6") ein Molekül (7, 7', 7") an ihrer Oberfläche exponiert, das dazu geeignet ist, spezifisch an ein Oberflächenmolekül einer zweiten Partikelart (8') zu binden.

3. Vorrichtung gemäß Anspruch 2, **dadurch gekennzeichnet, dass** das obere Kompartiment des Behälters mindestens eine dritte Gruppe von Festphase-Partikel (6, 6', 6") mit einem dritten hydrodynamischen Durchmesser enthält, wobei sich der dritte hydrodynamische Durchmesser von dem ersten und zweiten hydrodynamischen Durchmesser unterscheidet und wobei die dritte Gruppe von Festphase-Partikel (6, 6', 6") ein Molekül (7, 7', 7") an ihrer Oberfläche exponiert, das dazu geeignet ist, spezifisch an ein Oberflächenmolekül einer dritten Partikelart (8") zu binden, wobei das obere Kompartiment bevorzugt eine vierte, fünfte, sechste, siebte, achte, neunte und/oder zehnte Gruppe von Festphase-Partikel (6, 6', 6") mit jeweils einem hydrodynamischen Durchmesser enthält, der sich von anderen Gruppen an Festphase-Partikel (6, 6', 6") in dem oberen Kompartiment unterscheidet und wobei die Festphase-Partikel (6, 6', 6") der jeweiligen Gruppen ein Molekül (7, 7', 7") an ihrer Oberfläche exponieren, das dazu geeignet ist, spezifisch an ein Oberflächenmolekül einer jeweilig anderen Partikelart (8, 8', 8") zu binden.

4. Vorrichtung gemäß einem der vorhergehenden Ansprüche, **dadurch gekennzeichnet, dass** das mindestens eine Molekül (7, 7', 7"), das an der Oberfläche der Festphase-Partikel (6, 6', 6") exponiert ist und dazu geeignet ist, spezifisch an ein Oberflächenmolekül einer ersten Partikelart (8) zu binden,
i) eine Polypeptidkette enthält oder daraus besteht, wobei die Polypeptidkette bevorzugt ausgewählt ist aus der Gruppe bestehend aus Antikörper, Antikörper-Fragment und Derivaten hiervon, besonders bevorzugt ausgewählt ist aus der Gruppe bestehend aus Fab-Fragment oder Derivat hiervon; und/oder
ii) ein Polynukleotid enthält oder daraus besteht, wobei das Polynukleotid bevorzugt ausgewählt ist aus der Gruppe bestehend aus DNA, RNA und Derivaten hiervon; und/oder
iii) ein Oligosaccharid enthält oder daraus besteht; und/oder
iv) über nicht-kovalente Wechselwirkungen reversibel an der Oberfläche der Festphase-Partikel (6, 6', 6") gebunden ist, bevorzugt dergestalt, dass die Bindung lösbar ist über eine Maßnahme ausgewählt aus der Gruppe bestehend aus Veränderung einer Konzentration einer Substanz, Veränderung einer Temperatur, Veränderung des pH-Werts und Kombinationen hiervon; und/oder
v) dazu geeignet ist, spezifisch an ein Oberflächenmolekül einer Partikelart (8) zu binden, die einen kleineren hydrodynamischen Durchmesser als die Festphase-Partikel (6, 6', 6") aufweist, bevorzugt einen hydrodynamischen Durchmesser, der maximal 10%, bevorzugt maximal 8%, besonders bevorzugt maximal 6%, ganz besonders bevorzugt maximal 4%, insbesondere maximal 2%, des hydrodynamischen Durchmesser der Festphase-Partikels (6, 6', 6") beträgt.

5. Vorrichtung gemäß einem der vorhergehenden Ansprüche, **dadurch gekennzeichnet, dass** mindestens eine der mindestens zwei elektrisch leitfähigen Schichten (4, 4'), optional die mindestens zwei elektrisch leitfähige Schichten (4, 4')
i) auf der Oberseite oder auf der Unterseite des Filterelements (1) aufgebracht ist, wobei optional eine der Schichten (4, 4') auf der Oberseite des Filterelements (1) aufgebracht ist und die andere auf der Unterseite des Filterelements (1) aufgebracht ist; und/oder
ii) in einem Randbereich der Poren (2) des Filterelements (1) angeordnet ist; und/oder
iii) vollständig um die Poren (2) des Filterelements (1) angeordnet ist und an gleichen Stellen wie das Filterelement (1) durchgängige Poren (2) mit einem definierten Porendurchmesser aufweist; und/oder
iv) ein Metall enthält, wobei das Metall bevorzugt an der Oberfläche der elektrisch leitfähigen Schicht (4, 4') angeordnet ist; und/oder
v) kraftschlüssig und/oder stoffschlüssig mit dem Filterelement (1) oder einer elektrisch isolierenden Schicht (5, 5') verbunden ist;
wobei mindestens eine der mindestens zwei elektrisch leitfähigen Schichten (4, 4'), optional die mindestens zwei elektrisch leitfähigen Schichten (4, 4'), besonders bevorzugt über ein Verfahren ausgewählt aus der Gruppe bestehend aus Tampondruck, Rakeln, Siebdruck, Inkjet-Printing, Jetten, Sprühen, Bedampfen und Kombinationen hiervon, optional kombiniert mit einem Laser-Strukturierungsverfahren, auf das Filterelement (1) oder auf eine elektrisch leitfähige Schicht (4, 4') aufgebracht ist.

6. Vorrichtung gemäß einem der vorhergehenden Ansprüche, **dadurch gekennzeichnet, dass** die Vorrichtung ein Mittel aufweist, das dazu geeignet ist,
i) durch Einwirken einer mechanischen Kraft auf das Filterelement (1) den Porendurchmesser seiner Poren (2) zu verändern, wobei das Mittel ausgewählt ist aus der Gruppe bestehend aus Stempel zur Ausübung eines Drucks auf das Filterelement (1), pneumatische Vorrichtung zur Ausübung eines Drucks auf das Filterelement (1), Bi-Metall-Draht zur Ausübung eines Drucks auf das Filterelement (1), NiTiCu-Legierung zur Ausübung eines Drucks auf das Filterelement (1) und Kombinationen hiervon; und/oder
ii) an der Oberseitenfläche des Filterelements einen oszillierenden Fluidstrom anzulegen, bevorzugt einen Fluidstrom, der in einer Richtung senkrecht zur Oberseitenfläche des Filterelements (1) oszilliert.

7. Vorrichtung gemäß einem der vorhergehenden Ansprüche, **dadurch gekennzeichnet, dass** die Vorrichtung eine Steuereinheit aufweist, die konfiguriert ist, eine elektrische Spannung einer Spannungsquelle (3) und/oder eine mechanische Kraft auf das Filterelement (1) zu steuern, bevorzugt dergestalt, dass
i) eine elektrische Spannung und/oder eine mechanische Kraft auf das Filterelement (1) im Laufe einer Separation von Partikeln (8, 8', 8") in einer Flüssigkeit stufenweise verändert wird, wobei die Veränderung bevorzugt automatisch im Laufe der Zeit oder manuell durch Eingabe eines Benutzers erfolgt, wobei es sich insbesondere bei der Veränderung der elektrischen Spannung um eine Verringerung der elektrischen Spannung handelt und bei der Veränderung der mechanischen Kraft auf das Filterelement (1) um eine Verringerung der mechanischen Kraft auf das Filterelement (1) handelt; und/oder
ii) der Porendurchmesser der Poren (2) des Filterelements (1) in einem Bereich von 10 bis 200 µm, bevorzugt in einem Bereich von 20 bis 180 µm, besonders bevorzugt in einem Bereich von 30 bis 160 µm, insbesondere in einem Bereich von 40 bis 120 µm, verändert wird; und/oder
iii) der Porendurchmesser der Poren (2) des Filterelements (1) automatisch im Laufe der Zeit oder manuell durch Eingabe(n) von einem Benutzer der Vorrichtung schrittweise auf einen größeren Porendurchmesser verändert wird, bevorzugt in Schritten von 5 bis 15 µm, besonders bevorzugt in Schritten von 9 bis 11 µm, ganz besonders bevorzugt von einem Porendurchmesser von 10 µm bis zu einem Porendurchmesser von 200 µm, insbesondere von einem Porendurchmesser von 40 µm über einen Porendurchmesser von 50 µm, einen Porendurchmesser von 60 µm, einem Porendurchmesser von 70 µm, einem Porendurchmesser von 80 µm, einem Porendurchmesser von 90 µm, einem Porendurchmesser von 100 µm, einem Porendurchmesser von 110 µm bis zu einem Porendurchmesser von 120 µm.

8. Vorrichtung gemäß einem der vorhergehenden Ansprüche, **dadurch gekennzeichnet, dass** die Vorrichtung ein Mittel aufweist, das dazu geeignet ist, die Flüssigkeit mit Partikeln (8, 8', 8") durch das Filterelement (1) zu bewegen, wobei das Mittel bevorzugt
i) einen Stempel enthält oder daraus besteht, der flüssigkeitsdicht und beweglich in dem ersten Kompartiment des Behälters angeordnet ist; und/oder
ii) eine Fördereinrichtung, bevorzugt eine Pumpe, besonders bevorzugt eine Pumpe, die dazu konfiguriert ist, eine Flüssigkeit mit Partikeln (8, 8', 8") bidirektional durch das Filterelement (1) zu bewegen, enthält oder daraus besteht.

9. Vorrichtung gemäß einem der vorhergehenden Ansprüche, **dadurch gekennzeichnet, dass** das Filterelement (1) ein Material enthält oder daraus besteht, das
i) elektroaktiv ist; und/oder
ii) piezoelektrisch ist; und/oder
iii) dielektrisch ist; und/oder
iv) elastisch ist; und/oder
v) inkompressibel ist; und/oder
vi) ein Polymer, bevorzugt ein Elastomer, besonders bevorzugt ein thermoplastisches Elastomer, ist, wobei das Polymer insbesondere ausgewählt ist aus der Gruppe bestehend aus Silikon-Elastomer, Flüssigkautschuk-Elastomer und Kombinationen hiervon; und/oder

10. Vorrichtung gemäß einem der vorhergehenden Ansprüche, **dadurch gekennzeichnet, dass** das Filterelement (1)
i) eine Ausdehnung von der Oberseite in Richtung Unterseite im Bereich von ≤ 250 µm, bevorzugt im Bereich von ≤ 200 µm, besonders bevorzugt im Bereich von ≤ 150 µm, insbesondere im Bereich von ≤ 100 µm, aufweist; und/oder
ii) vorgespannt ist, bevorzugt über eine äquibiaxiale Vordehnung im Bereich zwischen 50% und 150% vorgespannt ist, wobei die Vorspannung besonders bevorzugt über eine Verbindung des Filterelements (1) mit einem festen Rahmen der Vorrichtung realisiert ist; und/oder
iii) durchgängige Poren (2) aufweist, die einen im Wesentlichen runden Querschnitt haben; und/oder
iv) dazu geeignet ist, den Porendurchmesser seiner durchgängigen Poren (2) durch Einwirkung einer elektrischen Spannung an das Filterelement (1) und/oder durch Einwirken einer mechanischen Kraft auf das Filterelement (1) in einem Bereich von 20 bis 180 µm, besonders bevorzugt in einem Bereich von 30 bis 160 µm, ganz besonders bevorzugt in einem Bereich von 40 bis 120 µm, zu verändern, wobei die Veränderung des Porendurchmessers insbesondere isotrop in alle Richtungen entlang einer Querschnittsfläche der Poren (2) erfolgt.

11. Vorrichtung gemäß einem der vorhergehenden Ansprüche, **dadurch gekennzeichnet, dass** die Partikel (8, 8', 8") ausgewählt sind aus der Gruppe bestehend aus Vesikeln und biologischen Zellen, bevorzugt ausgewählt aus der Gruppe bestehend aus Vesikeln und biologischen Zellen aus Blut, besonders bevorzugt ausgewählt aus der Gruppe bestehend aus endosomalen Vesikeln, exosomalen Vesikeln, Thrombocyten, Erythrocyten, Leukocyten und Kombinationen hiervon.

12. Kit, enthaltend
i) eine Vorrichtung gemäß einem der Ansprüche 1 bis 11; und
ii) ein Gerät, das mindestens eines, bevorzugt alle, der folgenden Mittel aufweist:
ein Mittel, das dazu geeignet ist, eine elektrische Spannung an das Filterelement (1) anzulegen, wobei das Mittel bevorzugt eine elektrische Spannungsquelle (3) enthält oder daraus besteht;
ein Mittel, das dazu geeignet ist, an der Oberseitenfläche des Filterelements (1) einen oszillierenden Fluidstrom anzulegen, bevorzugt einen Fluidstrom, der in einer Richtung senkrecht zur Oberseitenfläche des Filterelements (1) oszilliert; und
ein Mittel, das dazu geeignet ist, die Flüssigkeit mit Partikeln (8, 8', 8") durch das Filterelement (1) zu bewegen, wobei das Mittel bevorzugt ausgewählt ist aus der Gruppe bestehend aus Stempel, der flüssigkeitsdicht und beweglich in dem ersten Kompartiment des Behälters angeordnet ist, eine Fördereinrichtung, bevorzugt eine Pumpe, besonders bevorzugt eine Pumpe, die dazu konfiguriert ist, eine Flüssigkeit mit Partikeln (8, 8', 8") bidirektional durch das Filterelement (1) zu bewegen, und Kombinationen hiervon.

13. Verfahren zur Separation von Partikeln (8, 8', 8") in einer Flüssigkeit, umfassend die Schritte
a) Bereitstellen mindestens einer Gruppe von Festphase-Partikeln (6, 6', 6"), die einen bestimmten hydrodynamischen Durchmesser aufweisen und die mindestens ein Molekül (7, 7', 7") an ihrer Oberfläche exponieren, das dazu geeignet ist, spezifisch an ein Oberflächenmolekül einer ersten Partikelart (8) der Partikel (8, 8', 8") der Flüssigkeit zu binden;
b) Inkubieren der Flüssigkeit mit der mindestens einen Gruppe von Festphase-Partikeln (6, 6', 6"), bis die Festphase-Partikel (6, 6', 6") der mindestens einen Gruppe von Festphase-Partikeln (6, 6', 6") spezifisch an ein Oberflächenmolekül einer ersten Partikelart (8) der Partikel (8, 8', 8") der Flüssigkeit gebunden haben;
c) Bereitstellen eines Filterelements (1), das ein Material enthält oder daraus besteht, das dazu geeignet ist, durch Anlegen einer elektrischen Spannung an das Filterelement (1) und/oder durch Einwirken einer mechanischen Kraft auf das Filterelement (1) den Porendurchmesser seiner Poren (2) zu verändern;
d) Einstellen des Porendurchmessers der Poren (2) des Filterelements (1) über Anlegen einer elektrischen Spannung an das Filterelement (1) und/oder Einwirken einer mechanischen Kraft auf das Filterelement (1), sodass nur Partikel bis zu einem gewünschten Partikeldurchmesser das Filterelement (1) passieren können, wobei der eingestellte Partikeldurchmesser kleiner ist wie ein hydrodynamischer Durchmesser von der mindestens einen Gruppe von Festphase-Partikeln (6, 6', 6");
e) Bewegen der Flüssigkeit durch das Filterelement (1);
f) Isolieren der Flüssigkeit;
g) Erhöhung des Porendurchmessers der Poren (2) des Filterelements (1) durch Verringerung der Stärke der elektrischen Spannung und/oder durch Erhöhung der mechanischen Kraft auf das Filterelement (1), sodass Partikel (8, 8', 8") bis zu einem gewünschten, nun größeren Partikeldurchmesser das Filterelement (1) passieren können, wobei es sich bevorzugt um die Partikel (8) der ersten Partikelart handelt, die an die Gruppe von Festphase-Partikeln (6, 6', 6") gebunden sind;
h) Optional Zugabe einer Flüssigkeit, die bevorzugt keine Partikel (8, 8', 8") enthält, zu der Flüssigkeit mit den nicht passierten Partikeln (8, 8', 8");
i) Bewegen der Flüssigkeit durch das Filterelement (1);
j) Isolieren der Flüssigkeit, welche die Partikel (8) der ersten Partikelart enthält;
k) Optional Wiederholen der Schritte g) bis j), bis alle Partikel (8, 8', 8") der Flüssigkeit nach ihrer Größe separiert in getrennten Flüssigkeiten vorliegen;
**dadurch gekennzeichnet, dass** das Verfahren mit einer Vorrichtung gemäß einem der Ansprüche 1 bis 11 durchgeführt wird.

14. Verfahren zur Separation von Partikeln (8, 8', 8") in einer Flüssigkeit gemäß Anspruch 13, **dadurch gekennzeichnet, dass** das Verfahren die folgenden Schritte umfasst
i) Einstellen des Porendurchmessers der Poren (2) des Filterelements (1) der Vorrichtung über Anlegen einer elektrischen Spannung an das Filterelement (1) und/oder über Einwirken einer mechanischen Kraft auf das Filterelement (1), sodass nur Partikel (8, 8', 8") bis zu einem gewünschten Partikeldurchmesser das Filterelement (1) passieren können, wobei der eingestellte Partikeldurchmesser kleiner ist als ein hydrodynamischer Durchmesser von der mindestens einen Gruppe von Festphase-Partikeln (6, 6', 6");
ii) Befüllen des oberen Kompartiments des Behälters der Vorrichtung mit einer Flüssigkeit, die Partikel mit einer unterschiedlichen Größe enthält;
iii) Inkubieren der Flüssigkeit im oberen Kompartiment des Behälters der Vorrichtung mit der mindestens einen Gruppe von Festphase-Partikeln (6, 6', 6"), bis zumindest Festphase-Partikel (6, 6', 6") der mindestens einen Gruppe von Festphase-Partikeln (6, 6', 6") spezifisch an ein Oberflächenmolekül einer ersten Partikelart (8) der Partikel (8, 8', 8") gebunden haben;
iv) Bewegen der Flüssigkeit durch das Filterelement (1) der Vorrichtung in das untere Kompartiment des Behälters;
v) Isolieren der Flüssigkeit mit den passierten Partikeln aus dem unteren Kompartiment des Behälters der Vorrichtung;
vi) Erhöhung des Porendurchmessers der Poren (2) des Filterelements (1) der Vorrichtung durch Verringerung der Stärke der elektrischen Spannung und/oder durch Erhöhung einer mechanischen Kraft auf das Filterelement (1), sodass Partikel bis zu einem gewünschten, nun größeren Partikeldurchmesser das Filterelement (1) passieren können, wobei es sich bevorzugt um die Partikel (8) der ersten Partikelart handelt, die an die Gruppe von Festphase-Partikel (6, 6', 6") gebunden sind;
vii) Optional Befüllen des oberen Kompartiments des Behälters der Vorrichtung mit einer Flüssigkeit, die bevorzugt keine Partikel enthält;
viii) Bewegen der Flüssigkeit durch das Filterelement (1) der Vorrichtung in das untere Kompartiment des Behälters;
ix) Isolieren der Flüssigkeit, welche die Partikel (8) der ersten Partikelart enthält, aus dem unteren Kompartiment des Behälters der Vorrichtung;
x) Optional Wiederholen der Schritte vi) bis ix), bis alle Partikel der Flüssigkeit nach ihrer Größe separiert in getrennten Flüssigkeiten vorliegen.

15. Verwendung der Vorrichtung gemäß einem der Ansprüche 1 bis 11, und/oder des Kits gemäß Anspruch 12, zur Separation von Partikeln (8, 8', 8") unterschiedlicher Größe, die in einer Flüssigkeit vorliegen, bevorzugt zur
i) Isolation von einer oder mehreren Blutzellfraktionen aus Blut, bevorzugt zur Bereitstellung der Blutzellfraktionen für die Diagnostik und/oder zur Herstellung von Blutpräparaten, insbesondere zur Erzeugung von Zelltherapeutika; und/oder
ii) Isolation von Bakterienzellen aus Blut; und/oder
iii) Isolation von endosomalen oder exosomalen Vesikeln aus Blut, Blutserum oder Biosuspensionen, bevorzugt zur Bereitstellung von endosomalen Vesikeln für die Diagnostik und/oder zur Herstellung von Impfstoffen; und/oder
iv) Isolation von Gewebezellen aus gemischten Gewebezellfraktionen; und/oder
v) Isolation von Zellen aus gemischten Zellsuspensionen, die von Bioreaktoren stammen, wobei die Zellen bevorzugt ausgewählt sind aus der Gruppe bestehend aus Pflanzenzellen, tierischen Zellen, menschlichen Zellen, Bakterienzellen, Hefezellen und Kombinationen hiervon.

## Claims

1. A device (8, 8', 8") for separating particles in a liquid, comprising
a) a container for receiving a liquid (suspension),
b) an areal filter element (1) having an upper side surface and a lower side surface,
wherein the filter element (1) has continuous pores (2) having a defined pore diameter,
the filter element (1) being arranged in the receptacle such that it divides the receptacle, in the direction of the upper side surface of the filter element (1), into an upper compartment and, in the direction of the lower side surface of the filter element (1), into a lower compartment, so that particles (8, 8', 8") of a liquid in the upper compartment can only reach the lower compartment if they pass through the filter element (1), the upper compartment of the receptacle having an opening for receiving a liquid with particles (8, 8', 8"),
wherein the upper compartment of the container contains at least one group of solid phase particles (6, 6', 6") that have a specific hydrodynamic diameter and that expose at least one molecule (7, 7', 7") at their surface that is suitable to specifically bind to a surface molecule of a first type of particle (8),
wherein the filter element (1) comprises or consists of a material that is suitable to change, by application of an electrical voltage to the filter element (1) and/or by the action of a mechanical force on the filter element (1), the pore diameter of its pores (2),
wherein the device has an electrical voltage source (3);
wherein the device has at least two electrically conductive layers (4, 4') which are connected to the electrical voltage source (3),
wherein at least one of the at least two electrically conductive layers (4, 4') contacts at least one electrical insulation layer (5, 5'), which is arranged between the at least one electrically conductive layer (4, 4') and the filter element (1),
**characterized in that** the filter element (1) is suitable for changing the pore diameter of its continuous pores (2) in a range from 10 to 200 µm by the action of an electrical voltage on the filter element (1) and/or by the action of a mechanical force on the filter element (1),
wherein at least one of the at least two electrically conductive layers (4, 4) comprises a polymer and electrically conductive particles.

2. A device in accordance with claim 1, **characterized in that** the upper compartment of the container contains at least one second group of solid phase particles (6, 6', 6") having a second hydrodynamic diameter, with the second hydrodynamic diameter differing from the first hydrodynamic diameter, and with the at least one second group of solid phase particles (6, 6', 6") exposing a molecule (7, 7', 7") at their surface that is suitable to specifically bind to a surface molecule of a second type of particle (8').

3. A device in accordance with claim 2, **characterized in that** the upper compartment of the container contains at least one third group of solid phase particles (6, 6', 6") having a third hydrodynamic diameter, with the third hydrodynamic diameter differing from the first and second hydrodynamic diameters, and with the third group of solid phase particles (6, 6', 6") exposing a molecule (7, 7', 7") at their surface that is suitable to bind to a surface molecule of a third type of particle (8"), with the upper compartment preferably comprising a fourth, fifth, sixth, seventh, eighth, ninth, and/or tenth group of solid phase particles (6, 6', 6") each comprising a hydrodynamic diameter that differs from other groups of solid phase particles (6, 6', 6") in the upper compartment, and with the solid phase particles (6, 6', 6") of the respective groups exposing a molecule (7, 7', 7") at their surface that is suitable to specifically bind to a surface molecule of a respective other type of particle (8, 8', 8").

4. A device in accordance with one of the preceding claims, **characterized in that** the at least one molecule (7, 7', 7") that is exposed at the surface of the solid phase particles (6, 6', 6") and that is suitable to specifically bind to a surface molecule of a first type of particle (8);
i) comprises or consists of a polypeptide chain, with the polypeptide chain preferably being selected from the group consisting of antibody, antibody fragment, and derivatives thereof, particularly preferably selected from the group consisting or a fab fragment or a derivative thereof; and/or
ii) comprises or consists of a polynucleotide, with the polynucleotide preferably being selected from the group consisting of DNA, RNA, and derivatives thereof; and/or
iii) comprises or consists of an oligosaccharide; and/or
iv) is reversibly bound to the surface of the solid phase particles (6, 6', 6") via non-covalent interactions, preferably such that the binding is releasable via a measure selected from the group consisting of changing a concentration of a substance, changing a temperature, changing the pH, and combinations thereof; and/ or
v) is suitable to specifically bind to a surface molecule of a type of particle (8) that has a smaller hydrodynamic diameter than the solid phase particles (6, 6', 6"), preferably a hydrodynamic diameter that amounts to a maximum of 10%, preferably a maximum of 8%, particularly preferably a maximum of 6%, very particularly preferably a maximum of 4%, in particular a maximum of 2%, of the hydrodynamic diameter of the solid phase particles (6, 6', 6").

5. A device in accordance with one of the preceding claims, **characterized in that** at least one of the at least two electrically conductive layers (4, 4'), optionally the at least two electrically conductive layers (4, 4'),
i) is applied to the upper side or to the lower side of the filter element (1), with optionally one of the layers (4, 4') being applied to the upper side of the filter element (1) and the other being applied to the lower side of the filter element (1); and/or
ii) is arranged in a marginal region of the pores (2) of the filter element (1); and/or
iii) is fully arranged around the pores (2) of the filter element (1) and having continuous pores (2) having a defined pore diameter at the same points as the filter element (1); and/or
iv) comprises a metal, with the metal preferably being arranged at the surface of the electrically conductive layer (4, 4'); and/or
v) is connected to the filter element (1), or to an electrically insulating layer (5, 5'), with a friction-lock and/or a material bond;
wherein at least one of the at least two electrically conductive layers (4, 4'), optionally the at least two electrically conductive layers (4, 4'), is/are applied to the filter element (1) or to an electrically conductive layer (4, 4') via a process selected from the group consisting of pad printing, doctor knife coating, screen printing, inkjet printing, jetting, spraying, vaporization, and combinations thereof, optionally combined with a laser structuring process.

6. A device in accordance with one of the preceding claims, **characterized in that** the device has a means that is suitable to
i) vary the pore diameter of the pores (2) of the filter element (1) by the action of a mechanical force on said filter element (1), with the means being selected from the group consisting of a stamp for exerting a pressure on the filter element (1), a pneumatic device for exerting a pressure on the filter element (1), a bimetallic wire for exerting a pressure on the filter element (1), an NiTiCu alloy for exerting a pressure on the filter element (1), and combinations thereof; and/or
ii) apply an oscillating fluid flow, preferably a fluid flow that oscillates in a direction perpendicular to the upper side surface of the filter element, to the upper side surface of the filter element (1).

7. A device in accordance with one of the preceding claims, **characterized in that** the device has a control unit that is configured to control an electrical voltage of a voltage source (3) and/or a mechanical force on the filter element (1), preferably such that
i) an electrical voltage and/or a mechanical force on the filter element (1) is changed stepwise in the course of a separation of particles (8, 8', 8") in a liquid, with the variation preferably taking place automatically over the course of time or manually by an input of a user, with the variation of the electrical voltage in particular being a reduction of the electrical voltage, and the variation of the mechanical force on the filter element (1) in particular being a reduction of the mechanical force on the filter element (1); and/or
ii) the pore diameter of the pores (2) of the filter element (1) is changed in a range from 10 to 200 µm, preferably in a range from 20 to 180 µm, particularly preferably in a range from 30 to 160 µm, in particular in a range from 40 to 120 µm; and/or
iii) the pore diameter of the pores (2) of the filter element (1) is changed automatically over the course of time, or manually by input(s) by a user of the device, stepwise to a larger pore diameter, preferably in steps of 5 to 15 µm, particularly preferably in steps of 9 to 11 µm, very particularly preferably from a pore diameter of 10 µm up to a pore diameter of 200 µm, in particular from a pore diameter of 40 µm via a pore diameter of 50 µm, a pore diameter of 60 µm, a pore diameter of 70 µm, a pore diameter of 80 µm, a pore diameter of 90 µm,, a pore diameter of 100 µm, a pore diameter of 110 µm, up to a pore diameter of 120 µm.

8. A device in accordance with one of the preceding claims, **characterized in that** the device has a means that is suitable to move the liquid having particles (8, 8', 8") through the filter element (1), with the means preferably
i) comprising or consisting of a stamp that is arranged in a liquid tight and movable manner in the first compartment of the container and/or
ii) comprising or consisting of a conveying device, preferably a pump, particularly preferably a pump that is configured to move a liquid having particles (8, 8', 8") bidirectionally through the filter element (1).

9. A device in accordance with one of the preceding claims, **characterized in that** the filter element (1) comprises or consists of a material that
i) is electroactive; and/or
ii) is piezoelectric; and/or
iii) is dielectric; and/or
iv) is elastic;, and/or
v) is incompressible; and/or
vi) is a polymer, preferably an elastomer, particularly preferably a thermoplastic elastomer, with the polymer in particular being selected from the group consisting of silicone elastomer, liquid rubber elastomer, and combinations thereof.

10. A device in accordance with one of the preceding claims, **characterized in that** the filter element (1)
i) has an extent from the upper side in the direction of the lower side in the range from ≤ 250 µm, preferably in the range from ≤ 200 µm, particularly preferably in the range from ≤ 150 µm, in particular in the range from ≤ 100 µm; and/ or
ii) is pretensioned, preferably via an equibiaxial prestretching in the range between 50% and 150%, with the pretension preferably being implemented via a connection of the filter element (1) to a fixed frame of the device; and/or
iii) has continuous pores (2) that have a substantially round cross-section; and/or
iv) is suitable to change the pore diameter of its continuous pores (2) by the action of an electrical voltage on the filter element (1) and/or by the action of a mechanical force on the filter element (1) in a range from 20 to 180 µm, particularly preferably in a range from 30 to 160 µm, very particularly preferably in a range from 40 to 120 µm, with the variation of the pore diameter in particular taking place isotropically in all the directions along a cross-sectional surface of the pores (2).

11. A device in accordance with one of the preceding claims, **characterized in that** the particles (8, 8', 8") are selected from the group consisting of vesicles and biological cells, preferably selected from the group consisting of vesicles and biological cells of blood, particularly preferably selected from the group consisting of endosomal vesicles, exosomal vesicles, thrombocytes, erythrocytes, leukocytes, and combinations thereof.

12. A kit comprising
i) a device in accordance with one of the claims 1 to 11; and
ii) a unit that has at least one, preferably all, of the following means:
a means that is suitable to apply an electrical voltage to the filter element (1), with the means preferably comprising or consisting of an electrical voltage source (3);
a means that is suitable to apply an oscillating fluid flow to the upper side surface of the filter element (1), preferably a fluid flow that oscillates in a direction perpendicular to the upper side surface of the filter element (1); and
a means that is suitable to move the liquid having particles (8, 8', 8") through the filter element (1), with the means preferably being selected from the group consisting of a stamp that is arranged in a liquid tight and movable manner in the first compartment of the container, a conveying device, preferably a pump, particularly preferably a pump that is configured to move a liquid having particles (8, 8', 8") bidirectionally through the filter element (1), and combinations thereof.

13. A method for separating particles (8, 8', 8") in a liquid, comprising the steps
a) providing at least one group of solid phase particles (6, 6', 6") that have a specific hydrodynamic diameter and that expose at least one molecule (7, 7', 7") at their surface that is suitable to specifically bind to a surface molecule of a first type of particle (8) of the particles (8, 8', 8") of the liquid;
b) incubating the liquid having the at least one group of solid phase particles (6, 6', 6") until the solid phase particles (6, 6', 6") of the at least one group of solid phase particles (6, 6', 6") have been specifically bound to a surface molecule of a first type of particle (8) of the particles (8, 8', 8") of the liquid;
c) providing a filter element (1) that comprises or consists of a material that is suitable to change, by application of an electrical voltage to the filter element (1) and/or by the action of a mechanical force on the filter element (1), the pore diameter of its pores (2);
d) setting the pore diameter of the pores (2) of the filter element (1) via application of an electrical voltage to the filter element (1) and/or the action of a mechanical force on the filter element (1) so that only particles up to a desired particle diameter can pass through the filter element (1), with the set particle diameter being smaller than a hydrodynamic diameter of the at least one group of solid phase particles (6, 6', 6");
e) moving the liquid through the filter element (1);
f) isolating the liquid;
g) increasing the pore diameter of the pores (2) of the filter element (1) by reducing the power of the electrical voltage and/or by increasing the mechanical force on the filter element (1) so that particles (8, 8', 8") up to a desired, now larger particle diameter can pass through the filter element (1), with said particles preferably being the particles (8) of the first type of particle that are bound to the group of solid phase particles (6, 6', 6");
h) optionally adding a liquid that preferably does not comprise any particles (8, 8', 8") to the liquid having the particles (8, 8', 8") that have not passed through;
i) moving the liquid through the filter element (1);
j) isolating the liquid that contains the particles (8) of the first type of particle;
k) optionally repeating steps g) to j) until all particles (8, 8', 8") of the liquid are present in separate liquids, separated according to size;
**characterized in that** the method is carried out using an apparatus according to any one of the claims 1 to 11.

14. A method for separating particles (8, 8', 8") in a liquid in accordance with claim 13, **characterized in that** the method preferably comprises the following steps
i) setting the pore diameter of the pores (2) of the filter element (1) of the device via application of an electrical voltage to the filter element (1) and/or the action of a mechanical force on the filter element (1) so that only particles (8, 8', 8") up to a desired particle diameter can pass through the filter element (1), with the set particle diameter being smaller than a hydrodynamic diameter of the at least one group of solid phase particles (6, 6', 6");
ii) filling the upper compartment of the container of the device with a liquid that contains particles having different sizes;
iii) incubating the liquid in the upper compartment of the container of the device having the at least one group of solid phase particles (6, 6', 6") until at least solid phase particles (6, 6', 6") of the at least one group of solid phase particles (6, 6', 6") have specifically bound to a surface molecule of a first type of particle (8) of the particles (8, 8', 8");
iv) moving the liquid through the filter element (1) of the device into the lower compartment of the container;
v) isolating the liquid, including the passed particles, from the lower compartment of the receptacle of the device;
vi) increasing the pore diameter of the pores (2) of the filter element (1) of the device by reducing the power of the electrical voltage and/or by increasing a mechanical force on the filter element (1) so that particles up to a desired, now larger particle diameter can pass through the filter element (1), with said particles preferably being the particles (8) of the first type of particle that are bound to the group of solid phase particles (6, 6', 6");
vii) optionally filling the upper compartment of the container of the device with a liquid that preferably does not comprise any particles;
viii) moving the liquid through the filter element (1) of the device into the lower compartment of the container;
ix) isolating the liquid that comprises the particles (8) of the first type of particles from the lower compartment of the container of the device;
x) optionally repeating steps vi) to ix) until all the particles of the liquid are present separated by their size in separate liquids.

15. Use of the device in accordance with one of the claims 1 to 11 and/or the kit in accordance with claim 12, for separating particles (8, 8', 8") of different sizes that are present in a liquid, preferably for
i) isolating one or more blood cell fractions from blood, preferably for providing blood cell fractions for diagnostics and/or for producing blood products, in particular for creating cell therapeutics; and/or
ii) the isolation of bacterial cells of blood; and/or
iii) the isolation of endosomal or exosomal vesicles of blood, blood serum, or biosuspensions, preferably for providing endosomal vesicles for diagnosis and/or for manufacturing vaccines; and/or
iv) the isolation of tissue cells of mixed tissue fractions; and/or
v) isolating cells from mixed cell suspensions that originate from bioreactors, with the cells preferably being selected from the group consisting of plant cells, animal cells, human cells, bacteria cells, yeast cells, and combinations thereof.

## Revendications

1. Dispositif de séparation de particules (8, 8', 8") dans un liquide, comprenant
a) un récipient permettant d'accueillir un liquide (suspension),
b) un élément filtrant plat (1) comprenant une surface supérieure et une surface inférieure,
dans lequel l'élément filtrant (1) présente des pores continus (2) avec un diamètre de pore défini,
dans lequel l'élément filtrant (1) est agencé dans le récipient de telle manière qu'il divise le récipient en un compartiment supérieur, en direction de la surface supérieure de l'élément filtrant (1), et en un compartiment inférieur, en direction de la surface inférieure de l'élément filtrant (1), de sorte que des particules (8, 8', 8") d'un liquide du compartiment supérieur ne peuvent pénétrer ensuite dans le compartiment inférieur que si elles traversent l'élément filtrant (1), dans lequel le compartiment supérieur du récipient présente un orifice permettant d'accueillir un liquide comprenant des particules (8, 8', 8"),
dans lequel le compartiment supérieur du récipient contient au moins un groupe de particules en phase solide (6, 6', 6') qui présentent un certain diamètre hydrodynamique et qui exposent à leur surface au moins une molécule (7, 7', 7") appropriée pour se lier spécifiquement à une molécule de surface d'un premier type de particule (8),
dans lequel l'élément filtrant (1) contient un, ou est constitué d'un matériau approprié pour modifier le diamètre de pore de ses pores (2) grâce à l'application d'une tension électrique à l'élément filtrant (1) et/ou grâce à l'action d'une force mécanique sur l'élément filtrant (1),
dans lequel le dispositif présente une source de tension électrique (3) ;
dans lequel le dispositif présente au moins deux couches électriquement conductrices (4, 4') reliées à la source de tension électrique (3),
dans lequel au moins une des au moins deux couches électriquement conductrices (4, 4') vient en contact avec au moins une couche d'isolation électrique (5, 5') qui est agencée entre la au moins une couche électriquement conductrice (4, 4') et l'élément filtrant (1),
**caractérisé en ce que** l'élément filtrant (1) est approprié pour modifier le diamètre de pore de ses pores continus (2) grâce à l'action d'une tension électrique sur l'élément filtrant (1) et/ou grâce à l'action d'une force mécanique sur l'élément filtrant (1) dans une plage comprise entre 10 et 200 µm,
dans lequel au moins une des au moins deux couches électriquement conductrices (4, 4') contient un polymère et des particules électriquement conductrices.

2. Dispositif selon la revendication 1, **caractérisé en ce que** le compartiment supérieur du récipient contient au moins un deuxième groupe de particules en phase solide (6, 6', 6") qui présentent un deuxième diamètre hydrodynamique, dans lequel le deuxième diamètre hydrodynamique est différent du premier diamètre hydrodynamique et dans lequel le au moins un deuxième groupe de particules en phase solide (6, 6', 6") expose à la surface de celles-ci une molécule (7, 7', 7") appropriée pour se lier spécifiquement à une molécule de surface d'un deuxième type de particules (8').

3. Dispositif selon la revendication 2, **caractérisé en ce que** le compartiment supérieur du récipient contient au moins un troisième groupe de particules en phase solide (6, 6', 6") qui présentent un troisième diamètre hydrodynamique, dans lequel le troisième diamètre hydrodynamique est différent des premier et deuxième diamètres hydrodynamiques et dans lequel le troisième groupe de particules en phase solide (6, 6', 6") expose à la surface de celles-ci une molécule (7, 7', 7") appropriée pour se lier spécifiquement à une molécule de surface d'un troisième type de particules (8"), dans lequel le compartiment supérieur contient de préférence des quatrième, cinquième, sixième, septième, huitième, neuvième et/ou dixième groupes de particules en phase solide (6, 6', 6") qui présentent respectivement un diamètre hydrodynamique différent des autres groupes de particules en phase solide (6, 6', 6") dans le compartiment supérieur et dans lequel les particules en phase solide (6, 6', 6") des groupes respectifs exposent à leur surface une molécule (7, 7', 7") appropriée pour se lier spécifiquement à une molécule de surface d'un autre type de particules (8, 8', 8").

4. Dispositif selon l'une quelconque des revendications précédentes, **caractérisé en ce que** l'au moins une molécule (7, 7', 7") exposée à la surface des particules en phase solide (6, 6', 6') et appropriée pour se lier spécifiquement à une molécule de surface d'un premier type de particules (8)
i) contient, ou est constituée d'une chaîne polypeptidique, dans laquelle la chaîne polypeptidique est de préférence choisie dans le groupe constitué des anticorps, des fragments d'anticorps et des dérivés de ceux-ci, particulièrement de préférence choisie dans le groupe constitué des fragments Fab ou des dérivés de ceux-ci ; et/ou
ii) contient, ou est constituée d'un polynucléotide, dans lequel le polynucléotide est de préférence choisi dans le groupe constitué de l'ADN, de l'ARN et des dérivés de ceux-ci ; et/ou
iii) contient, ou est constituée de, un oligosaccharide ; et/ou
iv) est liée de manière réversible à la surface des particules en phase solide (6, 6', 6") par l'intermédiaire d'interactions non covalentes, de préférence de manière à ce que la liaison soit supprimable grâce à une opération choisie dans le groupe constitué de la modification d'une concentration d'une substance, la modification d'une température, la modification du pH et des combinaisons de celles-ci ; et/ou
v) est appropriée pour se lier spécifiquement à une molécule de surface d'un type de particule (8) qui présente un diamètre hydrodynamique inférieur à celui des particules en phase solide (6, 6', 6'), de préférence un diamètre hydrodynamique qui est au maximum de 10 %, de préférence au maximum de 8 %, particulièrement de préférence au maximum de 6 %, tout particulièrement de préférence au maximum de 4 %, en particulier au maximum de 2 %, du diamètre hydrodynamique des particules en phase solide (6, 6', 6").

5. Dispositif selon l'une quelconque des revendications précédentes, **caractérisé en ce qu'**au moins une des au moins deux couches électriquement conductrices (4, 4'), éventuellement les au moins deux couches électriquement conductrices (4, 4'),
i) est/sont appliquée(s) sur la face supérieure ou sur la surface inférieure de l'élément filtrant (1), dans lequel une des couches (4, 4') est éventuellement appliquée sur la face supérieure de l'élément filtrant (1) et l'autre est appliquée sur la face inférieure de l'élément filtrant (1) ; et/ou
ii) est/sont agencée(s) dans une région de bord des pores (2) de l'élément filtrant (1) ; et/ou
iii) est/sont agencée(s) complètement autour des pores (2) de l'élément filtrant (1) et présente(nt) aux mêmes endroits que l'élément filtrant (1) des pores traversants (2) avec un diamètre de pore défini ; et/ou
iv) contien(nen)t un métal, dans lequel le métal est de préférence agencé à la surface de la couche électriquement conductrice (4, 4') ; et/ou
v) est reliée(s) par complémentarité de force et/ou par complémentarité de matière à l'élément filtrant (1) ou à une couche électriquement isolante (5, 5') ;
dans lequel au moins une des au moins deux couches électriquement conductrices (4, 4'), éventuellement les au moins deux couches électriquement conductrices (4, 4'), est/sont appliquée(s) sur l'élément filtrant (1) ou sur une couche électriquement conductrice (4, 4') particulièrement de préférence grâce à un procédé choisi dans le groupe constitué de la tampographie, le raclage, la sérigraphie, l'impression par jet d'encre, la projection, la pulvérisation, la vaporisation et des combinaisons de ceux-ci, éventuellement combiné avec un procédé de structuration par laser.

6. Dispositif selon l'une quelconque des revendications précédentes, **caractérisé en ce que** le dispositif présente un moyen approprié pour
i) grâce à l'action d'une force mécanique sur l'élément filtrant (1), modifier le diamètre de pore des pores (2) de celui-ci, dans lequel le moyen est choisi dans le groupe constitué par un piston permettant d'exercer une pression sur l'élément filtrant (1), un dispositif pneumatique permettant d'exercer une pression sur l'élément filtrant (1), un fil bimétallique permettant d'exercer une pression sur l'élément filtrant (1), un alliage NiTiCu permettant d'exercer une pression sur l'élément filtrant (1) et des combinaisons de ceux-ci ; et/ou
ii) créer un flux de fluide oscillant sur la surface supérieure de l'élément filtrant, de préférence un flux de fluide qui oscille dans une direction perpendiculaire à la surface supérieure de l'élément filtrant (1).

7. Dispositif selon l'une quelconque des revendications précédentes, **caractérisé en ce que** le dispositif présente une unité de commande configurée pour commander une tension électrique d'une source de tension (3) et/ou une force mécanique sur l'élément filtrant (1), de préférence de telle manière que
i) une tension électrique et/ou une force mécanique sur l'élément filtrant (1) est modifiée progressivement au cours d'une séparation de particules (8, 8', 8") dans un liquide, dans lequel la modification intervient de préférence de manière automatique au fil du temps ou de manière manuelle grâce à l'entrée d'un utilisateur, en particulier lorsque la modification de la tension électrique est une réduction de la tension électrique et lorsque la modification de la force mécanique sur l'élément filtrant (1) est une réduction de la force mécanique sur l'élément filtrant (1) ; et/ou
ii) le diamètre de pore des pores (2) de l'élément filtrant (1) est modifié dans une plage comprise entre 10 et 200 µm, de préférence dans une plage comprise entre 20 et 180 µm, particulièrement de préférence dans une plage comprise entre 30 et 160 µm, en particulier dans une plage comprise entre 40 et 120 µm ; et/ou
iii) le diamètre de pore des pores (2) de l'élément filtrant (1) est modifié par incréments vers un diamètre de pore supérieur de manière automatique au fil du temps ou de manière manuelle grâce à une ou des entrée(s) d'un utilisateur du dispositif, de préférence par incréments compris entre 5 et 15 µm, particulièrement de préférence par incréments compris entre 9 et 11 µm, le plus particulièrement de préférence d'un diamètre de pore de 10 µm jusqu'à un diamètre de pore de 200 µm, en particulier d'un diamètre de pore de 40 µm jusqu'à un diamètre de pore de 120 µm en passant par un diamètre de pore de 50 µm, par un diamètre de pore de 60 µm, par un diamètre de pore de 70 µm, par un diamètre de pore de 80 µm, par un diamètre de pore de 90 µm, par un diamètre de pore de 100 µm, par un diamètre de pore de 110 µm.

8. Dispositif selon l'une quelconque des revendications précédentes, **caractérisé en ce que** le dispositif présente un moyen approprié pour déplacer le liquide avec des particules (8, 8', 8") à travers l'élément filtrant (1), dans lequel le moyen, de préférence,
i) contient, ou est constitué d'un piston qui est agencé de manière étanche aux liquides et mobile dans le premier compartiment du récipient ; et/ou
ii) contient, ou est constitué d'un dispositif de transport, de préférence d'une pompe, particulièrement de préférence d'une pompe configurée pour déplacer un liquide avec des particules (8, 8', 8') de manière bidirectionnelle à travers l'élément filtrant (1).

9. Dispositif selon l'une quelconque des revendications précédentes, **caractérisé en ce que** l'élément filtrant (1) contient, ou est constitué d'un matériau qui
i) est électroactif ; et/ou
ii) est piézoélectrique ; et/ou
iii) est diélectrique ; et/ou
iv) est élastique ; et/ou
v) est incompressible ; et/ou
vi) est un polymère, de préférence un élastomère, particulièrement de préférence un élastomère thermoplastique, dans lequel le polymère est en particulier choisi dans le groupe constitué d'un élastomère de silicone, d'un élastomère de caoutchouc liquide et de combinaisons de ceux-ci.

10. Dispositif selon l'une quelconque des revendications précédentes, **caractérisé en ce que** l'élément filtrant (1)
i) présente une dilatation à partir de la face supérieure en direction de la face inférieure dans la plage ≤ 250 µm, de préférence dans la plage ≤ 200 µm, particulièrement de préférence dans la plage ≤ 150 µm, en particulier dans la plage ≤ 100 µm ; et/ou
ii) est précontraint, de préférence est précontraint par l'intermédiaire d'un pré-étirement équibiaxial dans la plage comprise entre 50 % et 150 %, dans lequel la précontrainte est réalisée particulièrement de préférence par l'intermédiaire d'une liaison entre l'élément filtrant (1) et un cadre fixe du dispositif; et/ou
iii) présente des pores continus (2) qui ont une section transversale essentiellement ronde ; et/ou
iv) est approprié pour modifier le diamètre de pore de ses pores continus (2) grâce à l'action d'une tension électrique au niveau de l'élément filtrant (1) et/ou grâce à l'action d'une force mécanique sur l'élément filtrant (1) dans une plage comprise entre 20 et 180 µm, particulièrement de préférence dans une plage comprise entre 30 et 160 µm, le plus particulièrement de préférence dans une plage comprise entre 40 et 120 µm, dans lequel la modification du diamètre de pore intervient en particulier de manière isotrope dans toutes les directions le long d'une surface de section transversale des pores (2).

11. Dispositif selon l'une quelconque des revendications précédentes, **caractérisé en ce que** les particules (8, 8', 8') sont choisies dans le groupe constitué de vésicules et de cellules biologiques, de préférence choisie dans le groupe constitué de vésicules et de cellules biologiques de sang, particulièrement de préférence choisie dans le groupe constitué de vésicules endosomales, de vésicules exosomales, de thrombocytes, d'érythrocytes, de leucocytes et de combinaisons de ceux-ci.

12. Kit, contenant
i) un dispositif selon l'une quelconque des revendications 1 à 11 ; et
ii) un appareil présentant au moins un, de préférence la totalité, des moyens ci-dessous :
un moyen approprié pour appliquer une tension électrique à l'élément filtrant (1), dans lequel le moyen contient ou constitue de préférence une source de tension électrique (3) ;
un moyen approprié pour appliquer un flux de fluide oscillant à la surface supérieure de l'élément filtrant (1), de préférence un flux de fluide qui oscille dans une direction perpendiculaire à la surface supérieure de l'élément filtrant (1) ; et
un moyen approprié pour déplacer le liquide avec des particules (8, 8', 8") à travers l'élément filtrant (1), dans lequel le moyen est préférence choisi dans le groupe constitué d'un piston qui est agencé de manière étanche aux liquides et mobile dans le premier compartiment du récipient, d'un dispositif de transport, de préférence d'une pompe, particulièrement de préférence d'une pompe configurée pour déplacer un liquide avec des particules (8, 8', 8") de manière bidirectionnelle à travers l'élément filtrant (1), et de combinaisons de ceux-ci.

13. Procédé de séparation de particules (8, 8', 8") dans un liquide, comprenant les étapes consistant à :
a) fournir au moins un groupe de particules en phase solide (6, 6', 6") présentant un certain diamètre hydrodynamique et exposant à leur surface au moins une molécule (7, 7', 7") appropriée pour se lier spécifiquement à une molécule de surface d'un premier type de particule (8) des particules (8, 8', 8") du liquide ;
b) incuber le liquide avec le au moins un groupe de particules en phase solide (6, 6', 6") jusqu'à ce que les particules en phase solide (6, 6', 6") du au moins un groupe de particules en phase solide (6, 6', 6") se soient liées spécifiquement à une molécule de surface d'un premier type de particule (8) des particules (8, 8', 8') du liquide ;
c) fournir un élément filtrant (1) qui contient, ou est constitué d'un matériau approprié pour modifier le diamètre de pore de ses pores (2) grâce à l'application d'une tension électrique à l'élément filtrant (1) et/ou grâce à l'action d'une force mécanique sur l'élément filtrant (1),
d) Régler le diamètre de pore des pores (2) de l'élément filtrant (1) par l'intermédiaire de l'application d'une tension électrique à l'élément filtrant (1) et/ou de l'action d'une force mécanique sur l'élément filtrant (1), de sorte que seules des particules présentant jusqu'à un diamètre de particule souhaité peuvent traverser l'élément filtrant (1), dans lequel le diamètre de particule réglé est inférieur à un diamètre hydrodynamique du au moins un groupe de particules en phase solide (6, 6', 6") ;
e) déplacer le liquide à travers l'élément filtrant (1) ;
f) isoler le liquide ;
g) Augmenter le diamètre de pore des pores (2) de l'élément filtrant (1) grâce à une réduction de l'intensité de la tension électrique et/ou grâce à une augmentation de la force mécanique sur l'élément filtrant (1), de sorte que des particules (8, 8', 8') présentant jusqu'à un diamètre de particule souhaité et désormais supérieur peuvent traverser l'élément filtrant (1), dans lequel il s'agit de préférence des particules (8) du premier type de particules, lesquelles sont liées au groupe de particules en phase solide (6, 6', 6") ;
h) ajouter de manière facultative un liquide qui ne contient de préférence pas de particules (8, 8', 8") au liquide contenant les particules (8, 8', 8") qui n'ont pas traversé ;
i) déplacer le liquide à travers l'élément filtrant (1) ;
j) isoler le liquide contenant les particules (8) du premier type de particules ;
k) répéter de manière facultative les étapes g) à j) jusqu'à ce que toutes les particules (8, 8', 8") du liquide se trouvent dans des liquides séparés en ayant été séparées en fonction de leur taille ;
**caractérisé en ce que** le procédé est mis en œuvre avec un dispositif selon l'une quelconque des revendications 1 à 11.

14. Procédé de séparation de particules (8, 8', 8") dans un liquide selon la revendication 13, **caractérisé en ce que** le procédé comprend les étapes ci-dessous consistant à
i) Régler le diamètre de pore des pores (2) de l'élément filtrant (1) du dispositif par l'intermédiaire de l'application d'une tension électrique à l'élément filtrant (1) et/ou de l'action d'une force mécanique sur l'élément filtrant (1), de sorte que seules des particules (8, 8', 8") présentant jusqu'à un diamètre de particule souhaité peuvent traverser l'élément filtrant (1), dans lequel le diamètre de particule réglé est inférieur à un diamètre hydrodynamique du au moins un groupe de particules en phase solide (6, 6', 6") ;
ii) remplir le compartiment supérieur du réservoir du dispositif avec un liquide contenant des particules de différentes tailles ;
iii) Incuber le liquide avec le au moins un groupe de particules en phase solide (6, 6', 6") jusqu'à ce que les particules en phase solide (6, 6', 6") du au moins un groupe de particules en phase solide (6, 6', 6") se soient liées spécifiquement à une molécule de surface d'un premier type de particule (8) des particules (8, 8', 8') du liquide ;
iv) déplacer le liquide à travers l'élément filtrant (1) du dispositif dans le compartiment inférieur du réservoir ;
v) isoler, hors du compartiment inférieur du réservoir du dispositif, le liquide contenant les particules qui ont traversé ;
vi) Augmenter le diamètre de pore des pores (2) de l'élément filtrant (1) du dispositif grâce à une réduction de l'intensité de la tension électrique et/ou grâce à une augmentation d'une force mécanique sur l'élément filtrant (1), de sorte que des particules présentant jusqu'à un diamètre de particule souhaité et désormais supérieur peuvent traverser l'élément filtrant (1), dans lequel les particules (8) du premier type de particules sont de préférence celles qui sont liées au groupe de particules en phase solide (6, 6', 6") ;
vii) remplir de manière facultative le compartiment supérieur du réservoir de l'appareil avec un liquide qui ne contient de préférence pas de particules ;
viii) déplacer le liquide à travers l'élément filtrant (1) du dispositif dans le compartiment inférieur du réservoir ;
ix) isoler, hors du compartiment inférieur du réservoir du dispositif, le liquide contenant les particules (8) du premier type de particules ;
x) répéter de manière facultative les étapes vi) à ix) jusqu'à ce que toutes les particules du liquide se trouvent dans des liquides séparés en ayant été séparées en fonction de leur taille.

15. Utilisation du dispositif selon l'une quelconque des revendications 1 à 11, et/ou du kit selon la revendication 12, pour la séparation de particules (8, 8', 8") de différentes tailles présentes dans un liquide, de préférence
i) afin d'isoler une ou plusieurs fraction(s) de cellules sanguines à partir de sang, de préférence afin de fournir les fractions de cellules sanguines pour le diagnostic et/ou afin de produire des préparations sanguines, en particulier afin de produire des médicaments thérapie cellulaire ; et/ou
ii) afin d'isoler des cellules bactériennes à partir du sang ; et/ou
iii) afin d'isoler des vésicules endosomales ou exosomales à partir de sang, d'un sérum sanguin ou de biosuspensions, de préférence afin de fournir des vésicules endosomales pour le diagnostic et/ou la fabrication de vaccins ; et/ou
iv) afin d'isoler des cellules tissulaires à partir de fractions cellulaires tissulaires mixtes ; et/ou
v) afin d'isoler des cellules à partir de suspensions cellulaires mixtes issues de bioréacteurs, dans laquelle les cellules sont de préférence choisies dans le groupe constitué de cellules végétales, de cellules animales, de cellules humaines, de cellules bactériennes, de cellules de levure et de combinaisons de celles-ci.
